# EUROPEAN PATENT APPLICATION

(11) **EP 4 792 969 A1**
(43) Date of publication of application: **19.08.2026**
(21) Application number: 26156501.4
(22) Date of filing: 05.02.2026
(51) Int. Cl.: B23K 26/0622, B23K 26/082, B23K 26/53, G02B 27/00

(54) **APPARATUS FOR FABRICATING COVER WINDOW, METHOD FOR FABRICATING COVER WINDOW, AND ELECTRONIC DEVICE INCLUDING COVER WINDOW**

(30) Priority: 13.02.2025 KR 20250018397
(71) Applicant: Samsung Display Co., Ltd., Yongin-si, Gyeonggi-do 17113 (KR)
(72) Inventor: Mishchik, Konstantin, Yongin-si, Gyeonggi-do (KR); Kim, Hyung Sik, Yongin-si, Gyeonggi-do (KR); Shcheblanov, Nikita, Yongin-si, Gyeonggi-do (KR); Yoo, Kyung Han, Yongin-si, Gyeonggi-do (KR); Jang, Seung Hoon, Yongin-si, Gyeonggi-do (KR); Jung, Woo Hyun, Yongin-si, Gyeonggi-do (KR)
(74) Representative: Gulde & Partner

(57) **Abstract**

The present invention relates to an apparatus (LD) for fabricating a cover window (CW), a method for fabricating a cover window (CW), and an electronic device (1) including the cover window (CW) are provided. The apparatus (LD) includes: a laser module (LDM); and a laser scan driver (LDR) configured to drive the laser module (LDM), wherein the laser module (LDM) includes, a light source (LR) configured to output a first laser beam (BM), a diffractive element (DE) configured to diffract the first laser beam (BM) and convert it into a second laser beam including a plurality of spot beams (SPB) arranged along a virtual first curve (VLS), and an objective lens (OLNS) configured to focus the second laser beam onto a focal region (FF), and wherein the spot beams (SPB) are extended in different directions.

## Description

### BACKGROUND

### 1. Field

One or more embodiments of the present disclosure relate to an apparatus for fabricating a cover window, a method for fabricating a cover window, and an electronic device including a cover window.

### 2. Description of the Related Art

As the information-oriented society evolve, demand for display devices have been steadily increased in various forms. Such display devices may include (e.g., be) liquid-crystal display devices, field emission display devices, light-emitting display devices, and/or the like. Light-emitting display devices may include organic light-emitting display devices including organic light-emitting diodes as light-emitting elements, inorganic light-emitting display devices including inorganic light-emitting diodes as light-emitting elements, and/or the like.

To enhance the mechanical strength of a cover window included in or attached to a display device, the side surfaces of the cover window may be machined utilizing a computer numerical control (CNC) polishing device, followed by a wet etching process. However, the CNC process may result in defects such as wedges and/or chipping on the side surfaces of the cover window, which may increase the fabrication cost and reduce yield.

### SUMMARY

One or more aspects of embodiments of the present disclosure are directed toward an apparatus for fabricating a cover window that reduces the fabrication cost without compromising mechanical strength, and a method for fabricating a cover window.

One or more aspects of embodiments of the present disclosure are directed toward an electronic device including a cover window that reduces the fabrication cost without compromising mechanical strength.

It should be noted that the scope and aspects of the present disclosure are not limited to the above-mentioned aspects; and other aspects and effects of the present disclosure will be apparent to those skilled in the art from the following descriptions or learning by practice of the presented embodiments of the disclosure. However, the scope of the present disclosure is defined by the appended claims.

According to one or more embodiments of the present disclosure, an apparatus for fabricating a cover window includes a laser module and a laser scan driver configured to drive the laser module, wherein the laser module includes: a light source configured to output a first laser beam; a diffractive element configured to diffract the first laser beam and convert it into a second laser beam including a plurality of spot beams arranged along a virtual first curve; and an objective lens configured to focus the second laser beam onto a focal region, and wherein the spot beams are extended in different directions.

In one or more embodiments, centers of the spot beams may be located at different points of the virtual first curve, and the spot beams may be extended in directions of the respective tangents that touch the virtual first curve at the centers of the spot beams. For example, a center of each of the spot beams may be located at a different point of the virtual first curve, and each spot beam may be extended in a direction of a respective tangent that touches the virtual first curve at the center of that spot beam.

In one or more embodiments, the spot beams may overlap with adjacent ones at least partially.

In one or more embodiments, the diffractive element may include a diffraction pattern that diffracts the first laser beam and that may convert it into the second laser beam, wherein the apparatus may further include a first controller configured to control a shape of the diffraction pattern to adjust arrangement and shape of the spot beams, and the first controller may be configured to set first, second, and third parameters that specify three-dimensional position coordinates related to arrangement of each of the spot beams, and a fourth parameter that specifies a tilting angle associated with a shape of each of the spot beams.

In one or more embodiments, a maximum tilting angle of each of the spot beams may be θ_{M}, a numerical aperture of the objective lens may be NA_{obj}, a numerical aperture of each of the spot beams may be NAₛₚₒₜ, and a maximum tilting angle of each of the spot beams may satisfy the equation of ${θ}_{M} ≡ \frac{\left({NA}_{obj}-{NA}_{spot}\right)}{2}$.

In one or more embodiments, a wavelength of the first laser beam may be λ, a major axis length of each of the spot beams may be dₛₚₒₜ, and the numerical aperture NAₛₚₒₜ of each of the spot beams may satisfy the equation of ${NA}_{spot} = \frac{λ}{2 {d}_{spot}}$.

In one or more embodiments, the numerical aperture of the objective lens may be about 0.5 to about 0.7, and the numerical aperture of each of the spot beams may be about 0.3 to about 0.4.

In one or more embodiments, the first controller may be configured to perform a first operation process, a second operation process, and a third operation process, wherein the first operation process may include setting a target shape of the plurality of spot beams in the focal region, generating a plurality of first virtual laser beams by back-propagating the plurality of spot beams having the target shape to the diffraction pattern having an arbitrary shape, generating a single second virtual laser beam by combining the plurality of first virtual laser beams, and generating virtual spot beams by forward-propagating the single second virtual laser beam to the focal region through the diffraction pattern having the arbitrary shape, wherein the second operation process may include determining whether the target shape of the plurality of spot beams is identical (e.g., equal or substantially identical) to shapes of the virtual spot beams, wherein the first controller terminates the first to third operation processes if (e.g., when) the target shape of the spot beams is identical (e.g., equal or substantially identical) to the shapes of the virtual spot beams, or performs the third operation process if (e.g., when) the target shape of the spot beams is different from the shapes of the virtual spot beams, wherein the third operation process may include modifying the shape of the diffraction pattern by comparing the target shape of the spot beams with the shapes of the virtual spot beams, regenerating the plurality of first virtual laser beams by back-propagating the plurality of spot beams having the target shape through the diffraction pattern having the modified shape, combining the plurality of first virtual laser beams to regenerate the single second virtual laser beam, and regenerating the virtual spot beams by forward propagating the single second virtual laser beam to the focal region through the diffraction pattern having the modified shape, and wherein the first controller may be configured to repeat the second operation process and the third operation process until the target shape of the plurality of spot beams is identical (e.g., equal or substantially identical) to the shapes of the virtual spot beams.

In one or more embodiments, the laser module may receive a driving force from the laser scan driver and may move in a first direction, and may output a plurality of laser shots each including the plurality of spot beams, wherein the apparatus may further include a second controller configured to control an interval of the laser shots in the first direction, wherein the second controller may control the interval so that a standard deviation of shortest distances between adjacent ones of the spot beams of each of the laser shots may be minimized.

In one or more embodiments, the laser shots may include a first laser shot, a second laser shot, and a third laser shot each including the plurality of spot beams, wherein the first laser shot may include first to third spot beams each arranged along a second direction different from the first direction, the second laser shot may include fourth and fifth spot beams each arranged along the second direction, and the third laser shot may include a sixth spot beam, wherein the fourth spot beam may be arranged between the first and second spot beams in the first direction, the fifth spot beam may be arranged between the second and third spot beams in the first direction, and the sixth spot beam may be arranged between the fourth and fifth spot beams, and wherein the second controller may control the interval so that a shortest distance between the second spot beam and the fourth spot beam, a shortest distance between the second spot beam and the fifth spot beam, a shortest distance between the second spot beam and the sixth spot beam, a shortest distance between the fourth spot beam and the sixth spot beam, and a shortest distance between the fifth spot beam and the sixth spot beam may be equal to one another.

In one or more embodiments, an interval between the first laser shot and the second laser shot in the first direction may be equal to an interval between the second laser shot and the third laser shot.

In one or more embodiments, a spacing between adjacent spot beams may be all equal in each of the laser shots.

In one or more embodiments, the first laser beam may have a Gaussian shape.

In one or more embodiments, the second laser beam may be configured to process glass.

According to one or more embodiments of the present disclosure, there is provided a method for fabricating a cover window, the method including, forming a sketch line for forming a cover window by irradiating a mother glass with a laser beam, and etching the mother glass using an etchant to separate the cover window from the mother glass, wherein the laser beam includes a plurality of spot beams arranged along a virtual first curve, and wherein the spot beams are extended in different directions.

In one or more embodiments, a thickness of the mother glass may be reduced by the etching with the etchant, and the etchant may permeate the sketch line to form a side surface of the cover window along a shape of the virtual first curve.

In one or more embodiments, the sketch line may be formed by a plurality of laser shots formed by outputting the laser beam multiple times, wherein a spacing between the spot beams (e.g., adjacent spot beams) in each of the plurality of laser shots in a scan direction of the laser beam may be Δyₚ, wherein an interval between the plurality of laser shots in the scan direction of the laser beam may be dy, wherein an optimal variable capable of minimizing a surface roughness of the cover window may be k, and wherein the k satisfies the equation of $k = \frac{Δ {y}_{p}}{dy}$.

In one or more embodiments, an initial value of the Δyₚ may be set to be larger than a diameter of each of the spot beams in a process of deriving the optimal variable k.

According to one or more embodiments of the present disclosure, an electronic device includes: a display device including a cover window fabricated by the apparatus and a display panel located under the cover window; a processor configured to provide a driving signal to the display device; and a power module configured to provide power to the display device.

According to one or more embodiments of the present disclosure, an electronic device includes: a display device including a cover window fabricated by the method and a display panel located under the cover window; a processor configured to provide a driving signal to the display device; and a power module configured to provide power to the display device.

According to one or more embodiments of the present disclosure, it may fabricate a cover window that reduce the fabrication cost without compromising mechanical strength. For example, by employing a laser module that generates a plurality of spot beams arranged along a virtual curve and extended in different directions, the apparatus enables precise and efficient material processing. This approach reduces mechanical defects such as chipping and wedge formation that are commonly associated with conventional CNC-based machining, thereby improving yield and reducing the need for post-processing.

According to one or more embodiments of the present disclosure, an electronic device may include a cover window that reduce the fabrication cost without compromising mechanical strength. For example, the disclosed apparatus and method enable control over laser beam characteristics, such as the arrangement, shape, and/or tilting angle, of a plurality of spot beams through a diffraction pattern and a programmable controller. By adjusting parameters including three-dimensional position coordinates and tilting angles of the spot beams, the apparatus may generate a desired beam shape in the focal region. This capability allows for precise formation of a sketch line in the mother glass, which in turn facilitates accurate etching and separation of the cover window. As a result, the apparatus supports high-precision fabrication of cover windows with reduced surface roughness and improved edge quality, while reducing the occurrence of defects such as chipping.

It should be noted that effects and aspects of the present disclosure are not limited to those described above and other effects and aspects of the present disclosure will be apparent to those skilled in the art from the following descriptions.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The accompanying drawings are included to provide a further understanding of the present disclosure and are incorporated in and constitute a part of the present disclosure. The drawings illustrate embodiments of the present disclosure and, together with the description, serve to explain principles of the present disclosure. The above and other aspects and features of the present disclosure will become more apparent from the following descriptions of one or more example embodiments thereof with reference to the accompanying drawings, in which:
FIG. 1 is a perspective view showing an electronic device according to one or more embodiments of the present disclosure.
FIG. 2 is a perspective view showing a display device included in an electronic device according to one or more embodiments of the present disclosure.
FIG. 3 is a block diagram showing a display device according to one or more embodiments of the present disclosure.
FIG. 4 is an equivalent circuit diagram showing a pixel of a display device according to one or more embodiments of the present disclosure.
FIGS. 5 and 6 are each a cross-sectional view showing a display device according to one or more embodiments of the present disclosure.
FIG. 7 is a cross-sectional view showing a cross section of a display area of a display device according to one or more embodiments of the present disclosure.
FIG. 8 is a front perspective view showing a cover window according to one or more embodiments of the present disclosure.
FIG. 9 is a rear perspective view showing a cover window according to one or more embodiments of the present disclosure.
FIG. 10 is a plan view showing a cover window according to one or more embodiments of the present disclosure.
FIG. 11 is a cross-sectional view taken along the line X1 - X1' of FIG. 10 according to one or more embodiments of the present disclosure.
FIG. 12 is a flowchart for illustrating a method for fabricating a cover window according to one or more embodiments of the present disclosure.
FIG. 13 is a perspective view showing step (e.g., act or task) S110 of FIG. 12 according to one or more embodiments of the present disclosure.
FIG. 14 is a cross-sectional view taken along the line X2 - X2' of FIG. 13 according to one or more embodiments of the present disclosure.
FIG. 15 is a cross-sectional view showing step (e.g., act or task) S120 of FIG. 12 according to one or more embodiments of the present disclosure.
FIG. 16 is an enlarged view of the area A of FIG. 15 according to one or more embodiments of the present disclosure.
FIG. 17 is a perspective view showing an apparatus for fabricating a cover window according to one or more embodiments of the present disclosure.
FIG. 18 is a view schematically showing a three-dimensional shape of a sketch line according to one or more embodiments of the present disclosure.
FIG. 19 is a view schematically showing a two-dimensional shape of a sketch line on the xz plane according to one or more embodiments of the present disclosure.
FIG. 20 is a view schematically showing a two-dimensional shape of a plurality of spot beams formed on a sketch line in the xz plane according to one or more embodiments of the present disclosure.
FIG. 21 is an image showing a two-dimensional shape of a sketch line on the xz plane according to one or more embodiments of the present disclosure.
FIG. 22 is an image showing a two-dimensional shape of a sketch line on the xy plane according to one or more embodiments of the present disclosure.
FIG. 23 is an image showing a two-dimensional shape of each of the spot beams in the xz plane, taken along the lines XA - XA', XB - XB', XC - XC', XD - XD' and XE - XE' of FIG. 22 according to one or more embodiments of the present disclosure.
FIG. 24 is a block diagram showing a controller of an apparatus for fabricating a cover window according to one or more embodiments of the present disclosure.
FIG. 25 is a flowchart for illustrating a process of optimizing a shape of a diffractive element by a diffractive element controller according to one or more embodiments of the present disclosure.
FIGS. 26 and 27 are views schematically showing the process of optimizing the shape of the diffractive element by the diffractive element controller according to one or more embodiments of the present disclosure.
FIG. 28 is an image showing a cross-section of a cover window formed by a method for fabricating a cover window according to Comparative Example 1 of the present disclosure.
FIG. 29 is an image showing a 3D shape of a cover window formed by a method for fabricating a cover window according to Comparative Example 1 of the present disclosure.
FIG. 30 is an image showing a cross-section of a cover window formed by a method for fabricating a cover window according to one or more embodiments of the present disclosure.
FIG. 31 is an image showing a 3D shape of the cover window formed by the method for fabricating a cover window according to one or more embodiments of the present disclosure.
FIG. 32 is a perspective view showing a process of processing a mother glass with laser shots according to one or more embodiments of the present disclosure.
FIG. 33 is a view schematically showing a process of optimizing the spacing between the spot beams included in the laser shots according to one or more embodiments of the present disclosure.
FIG. 34 is an image showing a 3D shape of a cover window formed by a method for fabricating a cover window according to Comparative Example 2 of the present disclosure.
FIG. 35 is an image showing a 3D shape of the cover window formed by the method for fabricating a cover window according to one or more embodiments of the present disclosure.
FIG. 36 is a block diagram of an electronic device according to one or more embodiments of the present disclosure.
FIG. 37 is a view showing electronic devices according to a variety of embodiments of the present disclosure.

### DETAILED DESCRIPTION

The present disclosure will now be described more fully hereinafter with reference to the accompanying drawings, in which example and illustrative embodiments of the disclosure are shown. This disclosure may, however, be embodied in different forms and should not be construed as limited to the embodiments set forth herein. Rather, these embodiments are provided so that this disclosure will be thorough and complete, and will fully convey the scope of the disclosure as defined by the appended claims to those skilled in the art.

It will also be understood that if (e.g., when) a layer is referred to as being "on" another layer or substrate, it may be directly on the other layer or substrate, or one or more intervening layers may also be present therebetween. In contrast, "directly on" may refer to that there are no additional intervening layers between the layer or substrate and the other layer or substrate. The same or like reference numbers indicate the same or like components throughout the disclosure.

Hereinafter, example embodiments of the present disclosure will be described in more detail with reference to the accompanying drawings.

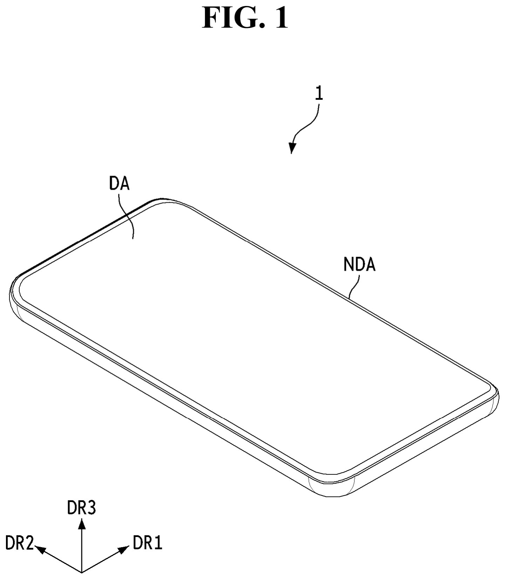

FIG. 1 is a perspective view showing an electronic device according to one or more embodiments of the present disclosure.

Referring to FIG. 1, an electronic device 1 may display moving images or still images. In the present disclosure, the electronic device 1 may refer to any electronic device that provides a display screen. For example, in one or more embodiments, the electron device 1 may include a television set, a laptop computer, a monitor, an electronic billboard, an Internet of Things device, a mobile phone, a smart phone, a tablet personal computer (PC), an electronic watch, a smart watch, a watch phone, a head-mounted display device, a mobile communications terminal, an electronic notebook, an electronic book, a portable multimedia player (PMP), a navigation device, a game console, a digital camera, a camcorder, and/or the like.

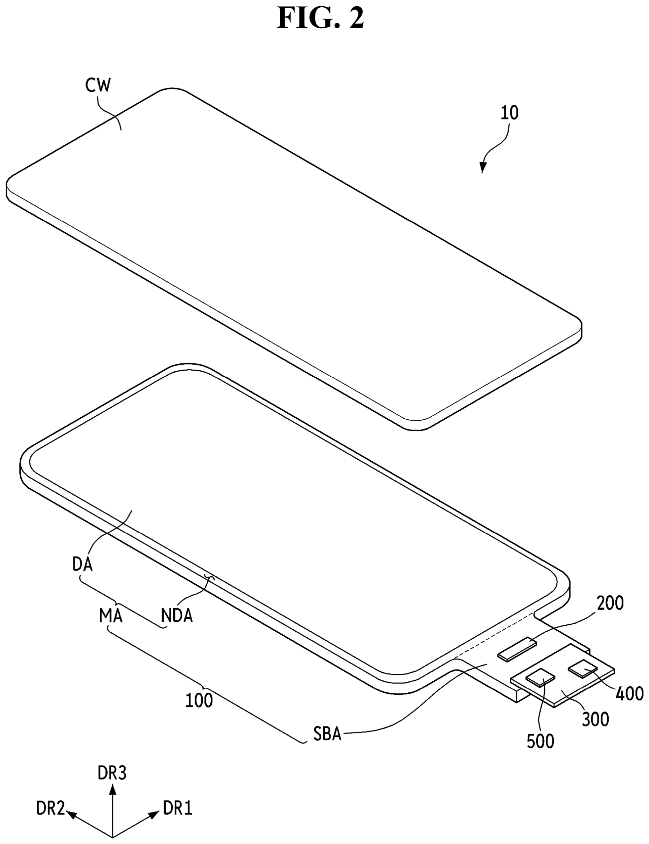

The electron device 1 may include a display device 10 (see FIG. 2) for providing a display screen. Non-limiting examples of the display device 10 may include an inorganic light-emitting diode display device, an organic light-emitting display device, a quantum-dot light-emitting display device, a plasma display device, a field emission display device, and/or the like. In the following description, an organic light-emitting diode display device is employed as an example of the display device, but embodiments of the present disclosure are not limited thereto. Any other display device may be employed as long as the technical idea of the present disclosure can be equally applied.

A shape of the electronic device 1 may be modified in a variety of ways. For example, in one or more embodiments, the electronic device 1 may have a shape such as a rectangle with longer lateral sides, a rectangle with longer vertical sides, a square, a quadrangle with rounded corners (vertices), another polygon, a circle, and/or the like. A shape of a display area DA of the electron device 1 may also be similar to the overall shape of the electron device 1. In the embodiment shown in FIG. 1, the electronic device 1 has a rectangular shape with longer sides in a second direction DR2 and shorter sides in a first direction DR1.

In the drawings, the first direction DR1 and the second direction DR2 intersect each other as the horizontal directions. For example, the first direction DR1 and the second direction DR2 may be perpendicular to each other. In addition, a third direction DR3 may intersect the first direction DR1 and the second direction DR2, and may be a vertical direction, for example. Herein, the side indicated by the arrow of each of the first to third directions DR1, DR2 and DR3 may be referred to as a first side, while the opposite side may be referred to as a second side unless specifically state otherwise. As used herein, the terms "on," "upper side," "above," "top," and "upper surface" refer to a side indicated by the arrow of the third direction DR3 as shown in the drawings. The terms "under," "lower side," "below," "bottom," and "lower surface" refer to a side opposite the side indicated by the arrow of the third direction DR3 as shown in the drawings.

In one or more embodiments, the electronic device 1 may include the display area DA and a non-display area NDA. In the display area DA, images may be displayed. In the non-display area NDA, images are not displayed. The display area DA may be referred to as an active area, while the non-display area NDA may also be referred to as an inactive area. The display area DA may generally occupy the center of the electronic device 1.

FIG. 2 is a perspective view showing a display device included in an electronic device according to one or more embodiments of the present disclosure.

Referring to FIG. 2 in conjunction with FIG. 1, the electronic device 1 according to one or more embodiments may include a display device 10. The display device 10 may provide a display screen of the electron device 1 where images are displayed. The display device 10 may have a shape similar to that of the electronic device 1 if (e.g., when) viewed from the top (e.g., in plan view). For example, in one or more embodiments, the display device 10 may have a shape similar to a rectangle having shorter sides in the first direction DR1 and longer sides in the second direction DR2. The corners where the shorter sides in the first direction DR1 meet the longer sides in the second direction DR2 may be rounded with a set or predetermined curvature. It should be understood, however, that embodiments of the present disclosure are not limited thereto. For example, in one or more embodiments, the corners may each be formed at a right angle. The shape of the display device 10 if (e.g., when) viewed from the top is not limited to a quadrangular shape, for example, may be formed in a shape similar to another polygonal shape, a circular shape, or an elliptical shape.

The display device 10 may include a cover window CW, a display panel 100, a driver circuit 200, a circuit board 300, a touch driver 400, and a power supply unit 500.

In one or more embodiments, the display panel 100 may include a main area MA and a subsidiary area SBA.

The main area MA may include the display area DA including pixels for displaying images, and the non-display area NDA located around the display area DA. The display area DA is located in the center of the main area MA, and the non-display area NDA may surround the display area DA. The display area DA may output lights from a plurality of emission areas or a plurality of open areas. For example, the display panel 100 may include a pixel circuit including switching elements, a pixel-defining layer that defines the emission areas or the open areas, and self-light-emitting elements.

For example, the self-light-emitting element may include, but is not limited to, at least one of: an organic light-emitting diode including an organic emissive layer, a quantum-dot light-emitting diode (quantum LED) including a quantum-dot emissive layer, an inorganic light-emitting diode (inorganic LED) including an inorganic semiconductor, or a micro light-emitting diode (micro LED).

The non-display area NDA may be located on an outer side of the display area DA. The non-display area NDA may be defined as an edge area of the main area MA of the display panel 100. The non-display area NDA may include a gate driver that provides gate signals to gate lines, and fan-out lines that connect the driver circuit 200 with the display area DA.

The subsidiary area SBA may be extended from one side of the main area MA. The subsidiary area SUB may include a flexible material that may be bent, folded, or rolled. For example, in one or more embodiments, if (e.g., when) the subsidiary area SBA is bent, the subsidiary area SBA may overlap the main area MA in a thickness direction (e.g., the third direction DR3). The subsidiary area SBA may include pads connected to the driver circuit 200 and the circuit board 300.

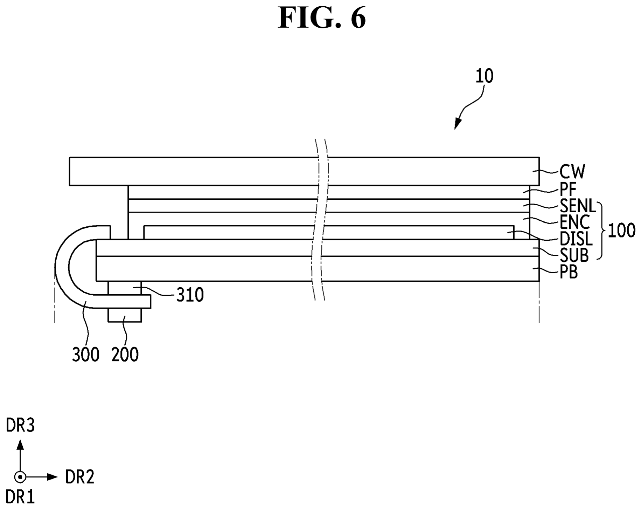

According to one or more embodiments, the subsidiary area SBA may not be provided, and the driver circuit 200 and the pads may be arranged in the non-display area NDA. In these embodiments, the circuit board 300 may be bent instead of the subsidiary area SBA, as shown in FIG. 6 which will be described in more detail later.

The driver circuit 200 may output signals and voltages for driving the display panel 100. The driver circuit 200 may provide data voltages to data lines. The driver circuit 200 may apply a supply voltage to a voltage line and may supply a gate control signal to a gate driver.

The driver circuit 200 may be implemented as an integrated circuit (IC) and may be attached on the display panel 100 by a chip-on-glass (COG) technique, a chip-on-plastic (COP) technique, or ultrasonic bonding. For example, in one or more embodiments, the driver circuit 200 may be located in the subsidiary area SBA and may overlap with the main area MA in the thickness direction as the subsidiary area SBA is bent. In one or more embodiments, the driver circuit 200 may be mounted on the circuit board 300.

The circuit board 300 may be attached on a pad area of the display panel 100 using an anisotropic conductive film (ACF). Lead lines of the circuit board 300 may be electrically connected to the pads of the display panel 100. The circuit board 300 may be a flexible printed circuit board (FPCB), a printed circuit board (PCB), or a flexible film such as a chip-on-film (COF).

The touch driver 400 may be mounted on the circuit board 300. The touch driver 400 may be connected to a touch sensing unit of the display panel 100. The touch driver 400 may supply a touch driving signal to a plurality of touch electrodes of the touch sensing unit and may sense a change in capacitance between the plurality of touch electrodes. For example, in one or more embodiments, the touch driving signals may be pulse signals having a set or predetermined frequency. The touch driver 400 may determine whether there is an input and may find the coordinates of the input based on the amount of the change in capacitance between the touch electrodes. The touch driver 400 may be implemented as an integrated circuit (IC).

The power supply unit 500 may be located on the circuit board 300 to apply a supply voltage to the driver circuit 200 and the display panel 100. The power supply unit 500 may generate a driving voltage to supply it to a driving voltage line, and may generate a common voltage to supply it to a common electrode. For example, the driving voltage may be a high-level voltage for driving a light-emitting element, and the common voltage may be a low-level voltage for driving the light-emitting element. The power supply unit 500 may generate an initialization voltage to supply it to an initialization voltage line, may generate a reference voltage to supply it to a reference voltage line, may generate a bias voltage to supply it to a bias voltage line, and may generate a reset voltage to supply it to a reset voltage line.

The cover window CW may be located on a front surface of the display panel 100 to protect the front surface of the display panel 100 from external impact. The cover window CW may be made of a transparent material. For example, in one or more embodiments, the cover window CW may be made of glass. In these embodiments, in order for the cover window CW to have foldable and flexible characteristics, the cover window CW may be ultra-thin glass (UTG) having a thickness of approximately 500 micrometers (µm) or less.

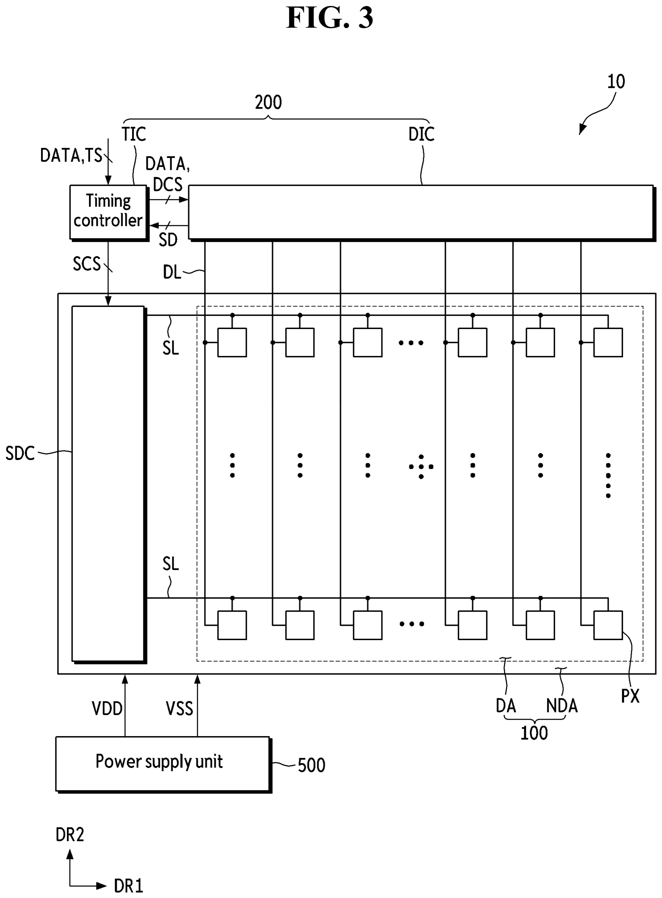

FIG. 3 is a block diagram showing a display device according to one or more embodiments of the present disclosure.

Referring to FIG. 3, a display device 10 according to one or more embodiments may include a display panel 100, a scan driver circuit SDC, a driver circuit 200, and a power supply unit 500.

The display panel 100 may include data lines DL, scan lines SL, and pixels PX. The scan lines SL may be extended in the first direction DR1 and arranged in the second direction DR2. The data lines DL may be extended in the second direction DR2 and may be arranged in the first direction DR1.

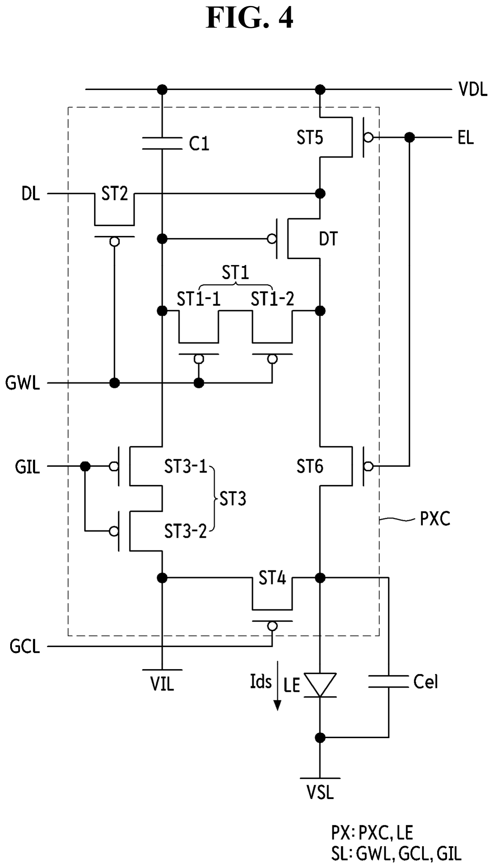

Each of the pixels PX may be connected to at least one of the data lines DL and at least one of the scan lines SL. As shown in FIG. 4, each of the pixels PX may include a light-emitting element LE (see FIG. 4), and a pixel circuit PXC (see FIG. 4) including a plurality of transistors for providing driving current to the light-emitting element LE (see FIG. 4). The pixel PX will be described later with reference to FIG. 4.

The scan driver circuit SDC and the driver circuit 200 may be referred to as a display panel driver. The driver circuit 200 may include a timing control circuit TIC (also referred as Timing controller) and a data driver circuit DIC.

The scan driver circuit SDC is connected to the scan lines SL and provides scan signals. The scan driver circuit SDC may generate scan signals in response to a scan timing control signal SCS input from the timing control circuit TIC and output the scan signals to the scan lines SL.

The scan driver circuit SDC may include a plurality of transistors. In one or more embodiments, the scan driver circuit SDC may be located in the non-display area NDA on the left side of the display panel 100. It should be understood, however, that the embodiments of the present disclosure are not limited thereto. The scan driver circuit SDC may be located in the non-display area NDA on the right side or the left and right sides of the display panel 100.

The data driver circuit DIC is connected to the data lines DL and provides data voltages. The data driver circuit DIC may receive digital video data DATA and a data timing control signal DCS from the timing control circuit TIC. The data driver circuit DIC may convert the digital video data DATA into data voltages in response to the data timing control signal DCS and output them to the data lines DL.

The timing control circuit TIC may receive the digital video data DATA and timing signals TS. The timing signals TS may include a vertical sync signal, a horizontal sync signal, a data enable signal, a clock signal such as a dot clock, and/or the like.

The timing control circuit TIC may generate control signals for controlling operation timings of the data driver circuit DIC and the scan driver circuit SDC. The control signals may include the data timing control signal DCS for controlling the operation timing of the data driver circuit DIC, and the scan timing control signal SCS for controlling the operation timing of the scan driver circuit SDC.

The timing control circuit TIC may output the digital video data DATA and the data timing control signal DCS to the data driver circuit DIC, and may output the scan timing control signal SCS to the scan driver circuit SDC.

The power supply unit 500 may generate a first supply voltage VSS corresponding to a low-level voltage and a second supply voltage VDD corresponding to a high-level voltage from a main power applied from an external source. In addition, the power supply unit 500 may provide one or more suitable driving voltages to the data driver circuit DIC, the scan driver circuit SDC, and the timing control circuit TIC.

FIG. 4 is an equivalent circuit diagram showing a pixel of a display device according to one or more embodiments of the present disclosure.

Referring to FIG. 4, a pixel PX according to one or more embodiments may include a pixel circuit unit PXC and a light-emitting element LE. The pixel PX may be connected to a first gate line GWL, a second gate line GCL, a third gate line GIL, an emission control line EL, a data line DL, a second voltage line VDL, a first voltage line VSL, and a third voltage line VIL. The first gate line GWL, the second gate line GCL, and the third gate line GIL constitutes the scan line SL.

The light-emitting element LE emits light as a driving current Ids flows therein. The amount (e.g., intensity) of the light emitted from the light-emitting element LE may be proportional to the driving current Ids.

In one or more embodiments, the light-emitting element LE may be an organic light-emitting element including an anode electrode, a cathode electrode, and an organic emissive layer arranged between the anode electrode and the cathode electrode. In one or more embodiments, the light-emitting element LE may be an inorganic light-emitting element including an anode electrode, a cathode electrode, and an inorganic semiconductor arranged between the anode electrode and the cathode electrode.

The anode electrode of the light-emitting element LE may be connected to a first electrode of the fourth transistor ST4 and a second electrode of the sixth transistor ST6, while the cathode electrode thereof may be connected to the first voltage line VSL. A parasitic capacitance Cel may be formed between the anode electrode and the cathode electrode of the light-emitting element LE.

The pixel circuit PXC includes a driving transistor DT, switching elements, and a capacitor C1. The switch elements include first to sixth transistors ST1, ST2, ST3, ST4, ST5 and ST6. In one or more embodiments, the first transistor ST1 may include a first-first transistor ST1-1 and a first-second transistor ST1-2 connected in series. The third transistor ST3 may include a third-first transistor ST3-1 and a third-second transistor ST3-2 connected in series.

The driving transistor DT includes a gate electrode, a first electrode, and a second electrode. The driving transistor DT controls a driving current flowing between the first electrode and the second electrode according to a data voltage applied to the gate electrode.

The capacitor C1 is formed between the gate electrode of the driving transistor DT and the second voltage line VDL. One electrode of the capacitor C1 may be connected to the gate electrode of the driving transistor DT while the other electrode thereof may be connected to the second voltage line VDL.

In one or more embodiments, if (e.g., when) the first electrode of each of the first to sixth transistors ST1, ST2, ST3, ST4, ST5, and ST6 and the driving transistor DT is a source electrode, the second electrode thereof may be a drain electrode. In one or more embodiments, if (e.g., when) the first electrode of each of the first to sixth transistors ST1, ST2, ST3, ST4, ST5, and ST6 and the driving transistor DT is a drain electrode, the second electrode thereof may be a source electrode.

An active layer of each of the first to sixth transistors ST1, ST2, ST3, ST4, ST5, and ST6 and the driving transistor DT may be made of one selected from among polysilicon, amorphous silicon, and an oxide semiconductor. If (e.g., when) the semiconductor layer (i.e., active layer) of each of the first to sixth transistors ST1 to ST6 and the driving transistor DT is made of polysilicon, a low-temperature poly silicon (LTPS) process may be employed.

Although the first to sixth transistors ST1, ST2, ST3, ST4, ST5, and ST6 and the driving transistor DT are implemented as P-type (kind) metal oxide semiconductor field effect transistors (MOSFETs), as shown in FIG. 4, this is merely illustrative. For example, in one or more embodiments, they may be implemented as N-type (kind) MOSFETs.

Moreover, a first supply voltage VSS from the first voltage line VSL, a second supply voltage VDD from the second voltage line VDL, and a third supply voltage (or an initialization voltage) from the third voltage line VIL may be determined based on the characteristics of the driving transistor DT, the characteristics of the light-emitting element LEL, and/or the like.

The pixel PX according to one or more embodiments of the present disclosure is not limited by one shown in FIG. 4. The pixel PX according to one or more embodiments of the present disclosure may have any other circuit structures suitable in the art than those of the embodiment shown in FIG. 4.

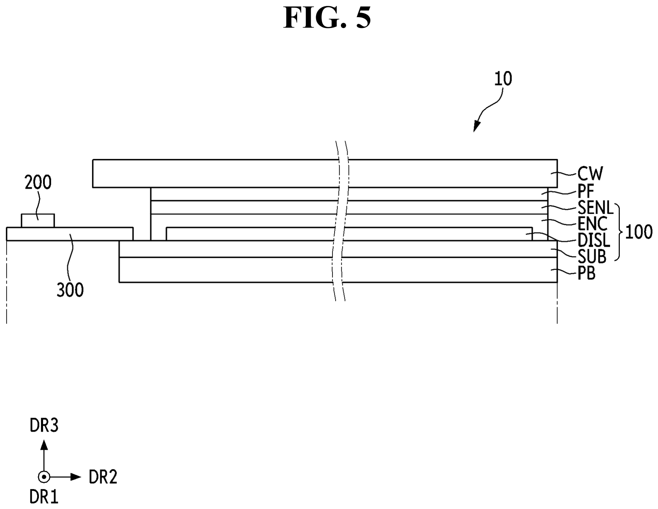

FIG. 5 and FIG. 6 are cross-sectional views showing a display device according to one or more embodiments of the present disclosure. FIG. 5 shows the circuit board 300 when it is unfolded. FIG. 6 shows the circuit board 300 when it is folded.

Referring to FIG. 5 and FIG. 6, the display device 10 according to one or more embodiments may include a display panel 100, a polarizing film PF, a cover window CW, and a panel bottom cover PB. The display panel 100 may include a substrate SUB, a display layer DISL, an encapsulation layer ENC, and a sensor electrode layer SENL.

The substrate SUB may be a flexible substrate that may be stretched and/or bent. The substrate SUB may be made of an insulating material. For example, in one or more embodiments, the substrate SUB may be made of a polymer resin such as an acryl resin, an epoxy resin, a phenolic resin, a polyamide resin, and/or a polyimide resin.

According to one or more embodiments, the substrate SUB may have a rigid material. For example, the substrate SUB may be made of glass. The substrate SUB may be formed of ultra-thin glass (UTG) having a thickness of approximately 500 µm or less. In one or more embodiments, the thickness of the substrate SUB may be approximately 200 µm.

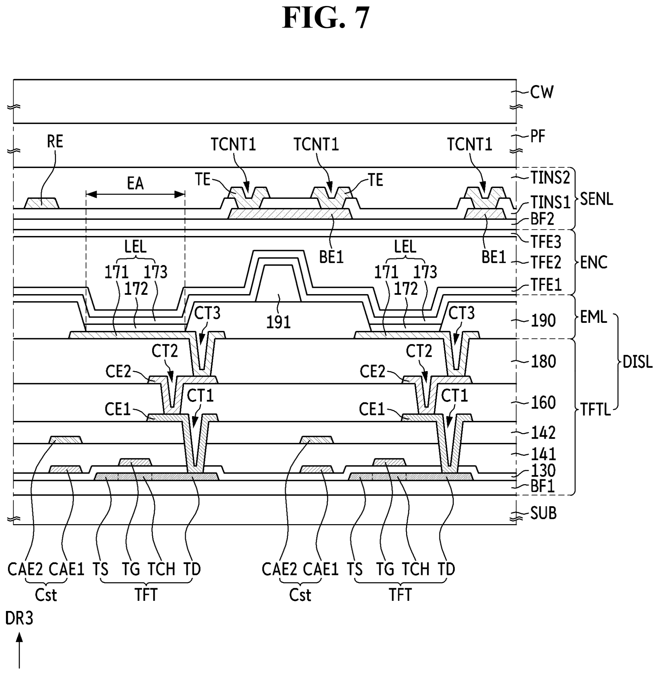

The display layer DISL may be located on a first surface of the substrate SUB. The display layer DISL may display images. The display layer DISL may include a thin-film transistor layer TFTL (see FIG. 7) in which thin-film transistors are formed, and an emission material layer EML (see FIG. 7) in which light-emitting elements that emit lights are arranged in emission areas.

In a display area DA of the display layer DISL (corresponding to the display area DA of the display panel 100), scan lines, data lines, voltage lines, and/or the like may be arranged so that lights are output from the emission areas. In a non-display area NDA of the display layer DISL (corresponding to the non-display area NDA of the display panel 100), a scan driver circuit for outputting scan signals to the scan lines, fan-out lines connecting the data lines with the driver circuit 200, and/or the like may be arranged.

The encapsulation layer ENC may encapsulate the emission material layer EML of the display layer DISL to prevent or reduce oxygen and/or moisture from permeating into the emission material layer EML of the display layer DISL. The encapsulation layer ENC may be located on the display layer DISL. The encapsulation layer ENC may be located on upper and side surfaces of the display layer DISL. The encapsulation layer ENC may cover the display layer DISL.

The sensor electrode layer SENL may be located on the display layer DISL. The sensor electrode layer SENL may include sensor electrodes. The sensor electrode layer SENL may sense a user's touch using the sensor electrodes.

The polarizing film PF may be located on the display panel 100 to prevent or reduce external light from being reflected off the display panel 100 to deteriorate the visibility of images displayed by the display panel 100. The polarizing film PF may include a first base member, a linear polarizer, a retardation film such as a quarter-wave (λ/4) plate, and a second base member. The first base member, the retardation film, the linear polarizer, and the second base member of the polarizing film PF may be sequentially stacked on the display panel 100.

According to one or more embodiments, an optical layer including a color filter instead of the polarizing film PF may be placed between the display panel 100 and the cover window CW. By including a plurality of color filters, the optical layer may prevent or reduce that external light is reflected off the display panel 100 and the visibility of images displayed on the display panel 100 is deteriorated.

The cover window CW may be located on the polarizing film PF. The cover window CW may be attached on the polarizing film PF by a transparent adhesive member such as an optically clear adhesive (OCA) film and/or an optically clear resin (OCR).

The panel bottom cover PB may be arranged on a second surface of the substrate SUB of the display panel 100. The second surface of the substrate SUB may be opposite to the first surface thereof. The panel bottom cover PB may be attached to the second surface of the substrate SUB of the display panel 100 by an adhesive member. The adhesive member may be a pressure-sensitive adhesive (PSA).

The panel bottom cover PB may include at least one of: a light-blocking member for absorbing light incident from outside, a buffer member for absorbing external impact, or a heat dissipating member for efficiently discharging heat from the display panel 100.

The light-blocking member may be located under the display panel 100. The light-blocking member blocks the transmission of light to prevent the elements arranged under the light-blocking member, such as the circuit board 300, from being seen from above the display panel 100. The light-blocking member may include a light-absorbing material such as a black pigment and/or a black dye.

The buffer member may be located under the light-blocking member. The buffer member absorbs an external impact to prevent or reduce the display panel 100 from being damaged. The buffer member may be made up of a single layer or multiple layers. For example, the buffer member may be formed of a polymer resin such as polyurethane, polycarbonate, polypropylene, and/or polyethylene, or may be formed of a material having elasticity such as a rubber and a sponge obtained by foaming a urethane-based material or an acrylic-based material.

The heat dissipating member may be arranged under the buffer member. The heat dissipation member may include a first heat dissipation layer including graphite and/or carbon nanotubes, and a second heat dissipation layer formed of a thin metal film such as copper, nickel, ferrite, and/or silver, which can block electromagnetic waves and have high thermal conductivity.

The circuit board 300 may be bent such that it is located under the display panel 100, as shown in FIG. 6. In one or more embodiments, the circuit board 300 may be attached to a lower surface of the panel bottom cover PB by an adhesive member 310. The adhesive member 310 may be a pressure-sensitive adhesive.

FIG. 7 is a cross-sectional view showing a cross section of a display area of a display device according to one or more embodiments of the present disclosure.

Referring to FIG. 7 in conjunction with FIGS. 5 and 6, a display panel 100 according to one or more embodiments of the present disclosure may be an organic light-emitting display panel including light-emitting elements LEL each including an organic emissive layer 172.

The substrate SUB has been described above with reference to FIGS. 5 and 6, and, therefore, the redundant descriptions will not be provided.

The display layer DISL may include a thin-film transistor layer TFTL including a plurality of thin-film transistors and an emission material layer EML including a plurality of light-emitting elements.

The thin-film transistor layer TFTL may include a first buffer film BF1, an active layer, a gate insulator 130, a first gate metal layer, a first interlayer dielectric layer 141, a second gate metal layer, a second interlayer dielectric layer 142, a first data metal layer, a first organic film 160, a second data metal layer, and a second organic film 180. The thin-film transistor layer TFTL may further include thin-film transistors TFT and capacitors Cst.

The first buffer film BF1 may be located on the substrate SUB. In one or more embodiments, the first buffer film BF1 may be formed of an inorganic material such as a silicon nitride layer, a silicon oxynitride layer, a silicon oxide layer, a titanium oxide layer, and/or an aluminum oxide layer. In one or more embodiments, the first buffer film BF1 may be made up of multiple layers in which two or more selected from among a silicon nitride layer, a silicon oxynitride layer, a silicon oxide layer, a titanium oxide layer, and an aluminum oxide layer are stacked on one another.

The active layer including a channel region TCH, a source region TS, and a drain region TD of each thin-film transistor TFT may be located on the first buffer film BF1. The active layer may be made of polycrystalline silicon, monocrystalline, low-temperature polycrystalline silicon, amorphous silicon, or an oxide semiconductor. If (e.g., when) the active layer includes polycrystalline silicon or an oxide semiconductor material, the source region TS and the drain region TD in the active layer may be conductive regions doped with ions or impurities to have relatively high conductivity.

The gate insulator 130 may be arranged on the active layer of the thin-film transistor TFT. The gate insulator 130 may include an inorganic layer, for example, a silicon nitride layer, a silicon oxynitride layer, a silicon oxide layer, a titanium oxide layer, or an aluminum oxide layer.

The first gate metal layer including a gate electrode TG of the thin-film transistor TFT, a first capacitor electrode CAE1 of a capacitor Cst, and scan lines may be arranged on the gate insulator 130. The gate electrode TG of the thin-film transistor TFT may overlap the channel region TCH thereof in the third direction DR3. The first gate metal layer may be made up of a single layer or multiple layers of one or more selected from among molybdenum (Mo), aluminum (Al), chromium (Cr), gold (Au), titanium (Ti), nickel (Ni), neodymium (Nd), and copper (Cu), or an alloy thereof.

The first interlayer dielectric layer 141 may be located on the first gate metal layer. The first interlayer dielectric layer 141 may include an inorganic layer, for example, a silicon nitride layer, a silicon oxynitride layer, a silicon oxide layer, a titanium oxide layer, or an aluminum oxide layer. In one or more embodiments, the first interlayer dielectric layer 141 may include a number of inorganic films.

The second gate metal layer including a second capacitor electrode CAE2 of the capacitor Cst may be located on the first interlayer dielectric layer 141. The second capacitor electrode CAE2 may overlap the first capacitor electrode CAE1 in the third direction DR3. Therefore, the capacitor Cst may be formed by the first capacitor electrode CAE1, the second capacitor electrode CAE2, and an inorganic insulating dielectric film (e.g., a portion of the first interlayer dielectric layer 141) located between the electrodes and serving as a dielectric film. The second gate metal layer may be made up of a single layer or multiple layers of one or more selected from among molybdenum (Mo), aluminum (Al), chromium (Cr), gold (Au), titanium (Ti), nickel (Ni), neodymium (Nd), and copper (Cu), or an alloy thereof.

The second interlayer dielectric layer 142 may be located on the second gate metal layer. The second interlayer dielectric layer 142 may include an inorganic layer, for example, a silicon nitride layer, a silicon oxynitride layer, a silicon oxide layer, a titanium oxide layer, or an aluminum oxide layer. In one or more embodiments, the second interlayer dielectric layer 142 may include a number of inorganic films.

The first data metal layer including first connection electrodes CE1 and data lines may be located on the second interlayer dielectric layer 142. The first connection electrode CE1 may be connected to the drain region TD through a first contact hole CT1 penetrating the gate insulator 130, the first interlayer dielectric film 141, and the second interlayer dielectric film 142. The first data metal layer may be made up of a single layer or multiple layers of one or more selected from among molybdenum (Mo), aluminum (Al), chromium (Cr), gold (Au), titanium (Ti), nickel (Ni), neodymium (Nd), and copper (Cu), or an alloy thereof.

The first organic film 160 may be arranged over the first connection electrode CE1 for providing a flat surface over the thin-film transistors TFT having uneven heights. The first organic film 160 may be formed as an organic layer made of, such as, an acryl resin, an epoxy resin, a phenolic resin, a polyamide resin, and/or a polyimide resin.

The second data metal layer including second connection electrodes CE2 may be arranged on the first organic film 160. The second data metal layer may be connected to the first connection electrode CE1 through a second contact hole CT2 penetrating the first organic film 160. The second data metal layer may be made up of a single layer or multiple layers of one or more selected from among molybdenum (Mo), aluminum (Al), chromium (Cr), gold (Au), titanium (Ti), nickel (Ni), neodymium (Nd), and copper (Cu), or an alloy thereof.

The second organic film 180 may be arranged on the second connection electrode CE2. The second organic film 180 may be formed as an organic layer made of, such as, an acryl resin, an epoxy resin, a phenolic resin, a polyamide resin, and/or a polyimide resin.

The emission material layer EML is located on the thin-film transistor layer TFTL. The emission material layer EML may include light-emitting elements LEL and a bank 190.

Each of the light-emitting elements LEL may include a pixel electrode 171, an emissive layer 172, and a common electrode 173. In each of emission areas EA, the pixel electrode 171, the emissive layer 172, and the common electrode 173 are stacked on one another sequentially, so that holes from the pixel electrode 171 and electrons from the common electrode 173 are combined with each other in the emissive layer 172 to emit light. In such case, the pixel electrode 171 may be an anode electrode while the common electrode 173 may be a cathode electrode.

A pixel electrode layer including the pixel electrodes 171 may be formed on the second organic film 180. The pixel electrode 171 may be connected to the second connection electrode CE2 through a third contact hole CT3 penetrating the second organic film 180. The pixel electrode layer may be made up of a single layer or multiple layers of one or more selected from among molybdenum (Mo), aluminum (Al), chromium (Cr), gold (Au), titanium (Ti), nickel (Ni), neodymium (Nd), and copper (Cu), or an alloy thereof.

In a top-emission structure where light exits from the emissive layer 172 toward the common electrode 173, the pixel electrode 171 may be made up of a single layer of molybdenum (Mo), titanium (Ti), copper (Cu), or aluminum (Al), or may be made up of a stack structure of aluminum and titanium (Ti/Al/Ti), a stack structure of aluminum and ITO (ITO/Al/ITO), an APC alloy, or a stack structure of APC alloy and ITO (ITO/APC/ITO) in order to increase the reflectivity. The APC alloy is an alloy of silver (Ag), palladium (Pd), and copper (Cu).

The bank 190 may define the emission areas EA of the pixels. In this regard, the bank 190 may be formed on the second organic film 180 to expose a part of the pixel electrode 171. The bank 190 may cover an edge of the pixel electrode 171. The bank 190 may be located inside the third contact hole CT3. For example, in one or more embodiments, the third contact hole CT3 may be filled with a material included in the bank 190. The bank 190 may include an organic film made of, such as, an acryl resin, an epoxy resin, a phenolic resin, a polyamide resin, and/or a polyimide resin.

A spacer 191 may be located on the bank 190. The spacer 191 may support a mask during a process of fabricating the emissive layer 172. The spacer 191 may be implemented as an organic layer made of, such as, an acryl resin, an epoxy resin, a phenolic resin, a polyamide resin, and/or a polyimide resin.

The emissive layer 172 is formed on the pixel electrode 171. The emissive layer 172 may include an organic material to emit light of a selected color. For example, the emissive layer 172 may include a hole transporting layer, an organic material layer, and an electron transporting layer. The organic material layer may include a host and a dopant. The organic material layer may include a material that emits light with a selected color, and may be formed using a phosphor and/or a fluorescent material.

The common electrode 173 is formed on the emissive layer 172. The common electrode 173 may be formed to cover the emissive layer 172. The common electrode 173 may be a common layer formed across all emission areas. In one or more embodiments, a capping layer may be formed on the common electrode 173.

In the top-emission structure, the common electrode 173 may be formed of a transparent conductive material (TCP) such as ITO and IZO that may transmit light, or a semi-transmissive conductive material such as magnesium (Mg), silver (Ag), or an alloy of magnesium (Mg) and silver (Ag). If (e.g., when) the common electrode 173 is made of a semi-transmissive metal material, the light extraction efficiency may be increased by using microcavities.

The encapsulation layer ENC may be formed on the emission material layer EML. The encapsulation layer ENC may include one or more selected from inorganic films TFE1 and TFE3 to prevent or reduce permeation of oxygen and/or moisture into the emission material layer EML. In addition, the encapsulation layer ENC may include at least one organic film to protect the emission material layer EML from particles such as dust. For example, in one or more embodiments, the encapsulation layer ENC may include a first inorganic encapsulation film TFE1, an organic encapsulation film TFE2, and a second inorganic encapsulation film TFE3.

The first inorganic encapsulation film TFE1 may be located on the common electrode 173, the organic encapsulation film TFE2 may be located on the first inorganic encapsulation film TFE1, and the second inorganic encapsulation film TFE3 may be located on the organic encapsulation film TFE2. In one or more embodiments, the first inorganic encapsulation film TFE1 and the second inorganic encapsulation film TFE3 may each be made up of multiple layers in which two or more inorganic layers selected from a silicon nitride layer, a silicon oxynitride layer, a silicon oxide layer, a titanium oxide layer, and an aluminum oxide layer are alternately stacked on one another. The organic encapsulation film TFE2 may be an organic film made of, such as, an acryl resin, an epoxy resin, a phenolic resin, a polyamide resin, a polyimide resin, and/or the like.

The sensor electrode layer SENL is located on the encapsulation layer ENC. The sensor electrode layer SENL may include sensor electrodes TE and RE.

In one or more embodiments, a second buffer film BF2 may be located on the encapsulation layer ENC. The second buffer film BF2 may include at least one inorganic film. For example, in one or more embodiments, the second buffer film BF2 may be made up of multiple layers in which two or more inorganic layers selected from a silicon nitride layer, a silicon oxynitride layer, a silicon oxide layer, a titanium oxide layer, and an aluminum oxide layer are alternately stacked on one another. In one or more embodiments, the second buffer film BF2 may not be provided.

First bridges BE1 may be located on the second buffer film BF2. The first bridges BE1 may be made up of a single layer of molybdenum (Mo), titanium (Ti), copper (Cu), or aluminum (Al), or may be made up of a stack structure of aluminum and titanium (Ti/Al/Ti), a stack structure of aluminum and ITO (ITO/Al/ITO), an APC alloy, or a stack structure of an APC alloy and ITO (ITO/APC/ITO).

A first sensor insulating layer TINS1 may be located on the first bridges BE1. The first sensor insulating layer TINS1 may be formed of an inorganic layer, for example, a silicon nitride layer, a silicon oxynitride layer, a silicon oxide layer, a titanium oxide layer, or an aluminum oxide layer.

The sensor electrodes, i.e., driving electrodes TE and sensing electrodes RE may be arranged on the first sensor insulating layer TINS1. In addition, dummy patterns may be arranged on the first sensor insulating layer TNIS1. The driving electrodes TE, the sensing electrodes RE, and the dummy patterns do not overlap the emission areas EA. The driving electrodes TE, the sensing electrodes RE, and the dummy patterns may each be made up of a single layer of molybdenum (Mo), titanium (Ti), copper (Cu), or aluminum (Al), or may be made up of a stack structure of aluminum and titanium (Ti/Al/Ti), a stack structure of aluminum and ITO (ITO/Al/ITO), an APC alloy, or a stack structure of an APC alloy and ITO (ITO/APC/ITO).

A second sensor insulating layer TINS2 may be arranged on the driving electrodes TE, the sensing electrodes RE, and the dummy patterns. The second sensor insulating layer TINS2 may include at least one of an inorganic film or an organic film. The inorganic film may be a silicon nitride layer, a silicon oxynitride layer, a silicon oxide layer, a titanium oxide layer, or an aluminum oxide layer. The organic film may be a film made of an acryl resin, an epoxy resin, a phenolic resin, a polyamide resin, and/or a polyimide resin.

The polarizing film PF and the cover window CW have been described above with reference to FIGS. 5 and 6, and, therefore, the redundant descriptions will not be provided for conciseness.

The display device 10 according to one or more embodiments of the present disclosure is not limited to the display device 10 including the organic emissive layer 172 shown in FIG. 7. For example, the display device 10 according to one or more embodiments of the present disclosure may be a display device 10 including inorganic light-emitting diodes, quantum-dot light-emitting diodes, and/or the like.

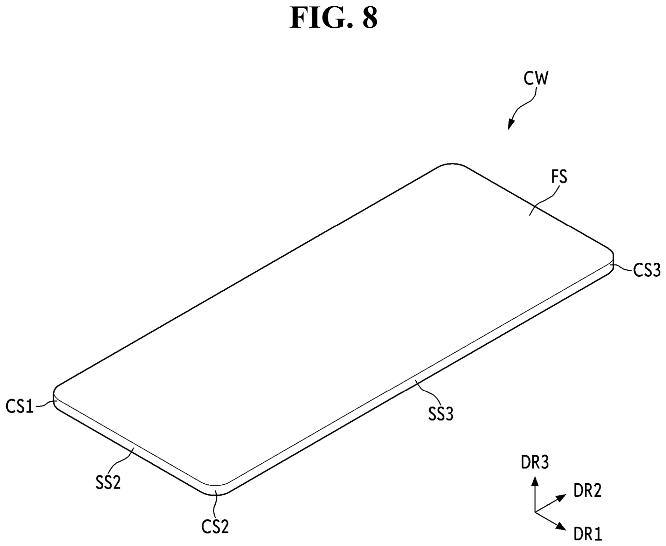

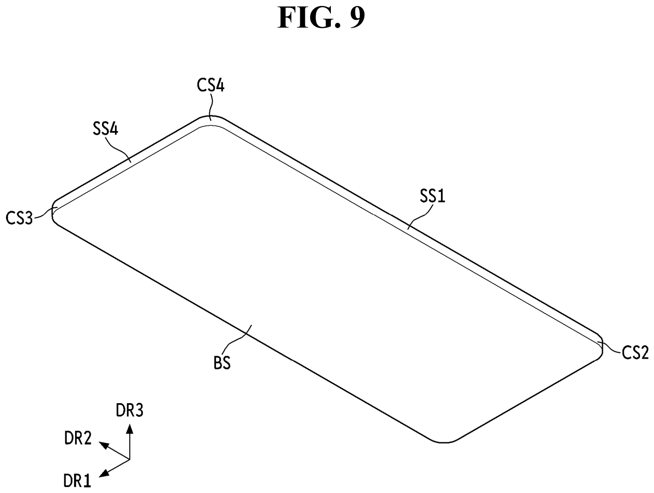

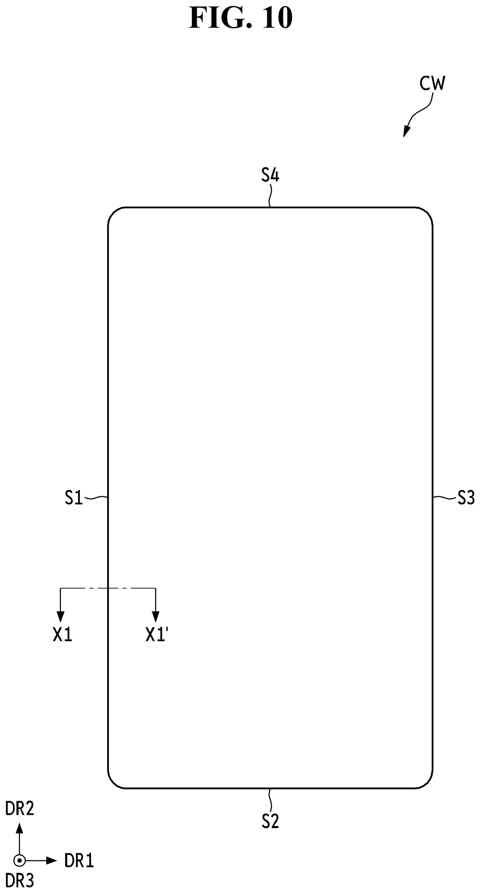

FIG. 8 is a front perspective view showing a cover window according to one or more embodiments of the present disclosure. FIG. 9 is a rear perspective view showing the cover window according to one or more embodiments. FIG. 10 is a plan view showing the cover window according to one or more embodiments.

Referring to FIGS. 8 to 10, the cover window CW includes a front surface FS, a back surface BS, first to fourth side surfaces SS1, SS2, SS3, and SS4, and first to fourth corner surfaces CS1, CS2, CS3, and CS4.

The front surface FS may have shorter sides in the first direction DR1 and longer sides in the second direction DR2. On the front surface FS, each of the corners where the shorter sides in the first direction DR1 meet the longer sides in the second direction DR2 may be rounded with a selected radius of curvature or may be a right angle. The front surface FS may be formed flat or may include a curved portion having a selected radius of curvature.

The first side surface SS1 may be extended from a first side S1 of the front surface FS, and the first side S1 of the front surface FS may be a left side of the front surface FS. The second side surface SS2 may be extended from a second side S2 of the front surface FS, and the second side S2 of the front surface FS may be a lower side of the front surface FS. The third side surface SS3 may be extended from a third side S3 of the front surface FS, and the third side S3 of the front surface FS may be a right side of the front surface FS. The fourth side surface SS4 may be extended from a fourth side S4 of the front surface FS, and the fourth side S4 of the front surface FS may be an upper side of the front surface FS.

The first corner CS1 may be a corner side surface located between the first side surface SS1 and the second side surface SS2. The second corner CS2 may be a corner side surface located between the second side surface SS2 and the third side surface SS3. The third corner CS3 may be a corner side surface located between the third side surface SS3 and the fourth side surface SS4. The fourth corner CS4 may be a corner side surface located between the first side surface SS1 and the fourth side surface SS4 (i.e., between the fourth side surface SS4 and the first side surface SS1).

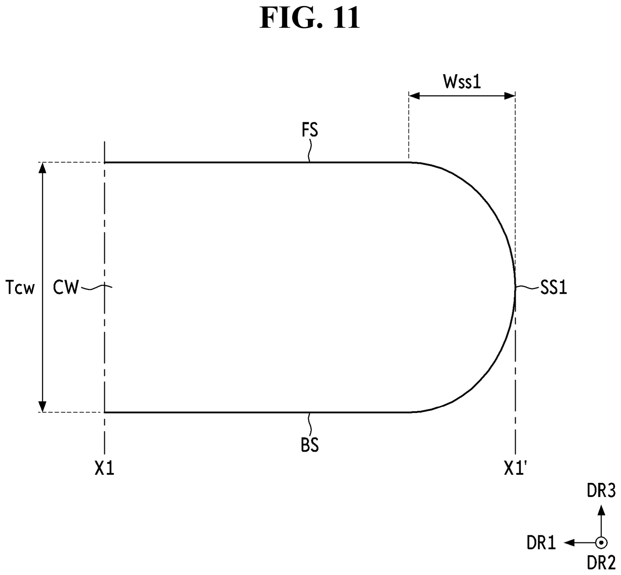

FIG. 11 is a cross-sectional view taken along the line X1 - X1' of FIG. 10 according to one or more embodiments. FIG. 11 is a cross-sectional view showing the first side surface SS1 of the cover window CW. Because the second to fourth side surfaces SS2, SS3, and SS4 of the cover window CW may have substantially the same shape except for different directions, only the first side surface SS1 will be described.

Referring to FIG. 11, the first side surface SS1 of the cover window CW may have a curved shape having a selected radius of curvature. The radius of curvature of the first side surface SS1 of the cover window CW may be approximately about 15R to about 25R. Because the radius of curvature of the first side surface SS1 of the cover window CW is about 15R to about 25R, the impact strength of the first side surface SS1 may be increased.

The radius of curvature of the first side surface SS1 may substantially be the same or different at different points of the first side surface SS1. If (e.g., when) the curvature radius of the first side surface SS1 is different at different points of the first side surface SS1, the curvature radius of the first side surface SS1 may be defined as an average value of the curvature radius at different points of the first side surface SS1.

According to one or more embodiments of the present disclosure, a width Wss1 of the first side surface SS1 of the cover window CW, i.e., a length in the first direction DR1 may be approximately about 10 µm to about 20 µm, and a thickness Tcw of the cover window CW may be approximately about 30 µm to about 60 µm.

Hereinafter, a method for fabricating a cover window according to one or more embodiments of the present disclosure will be described.

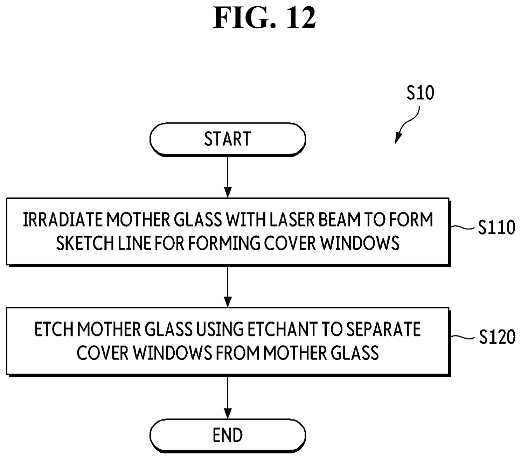

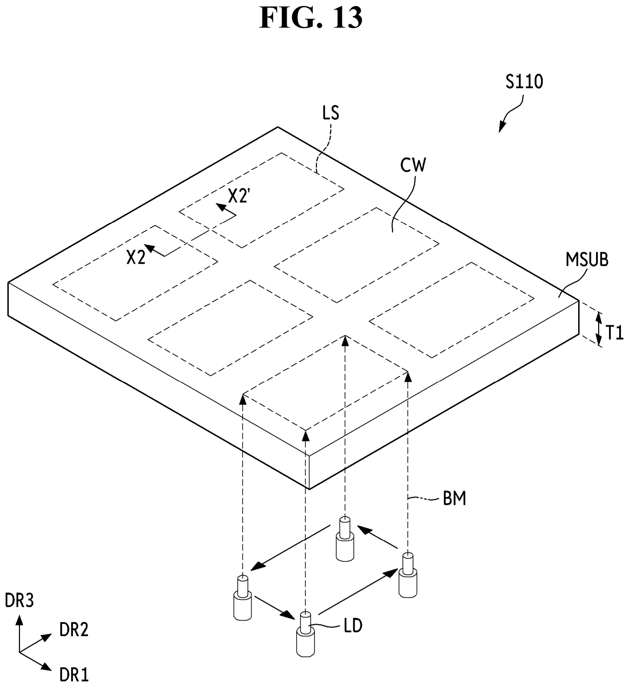

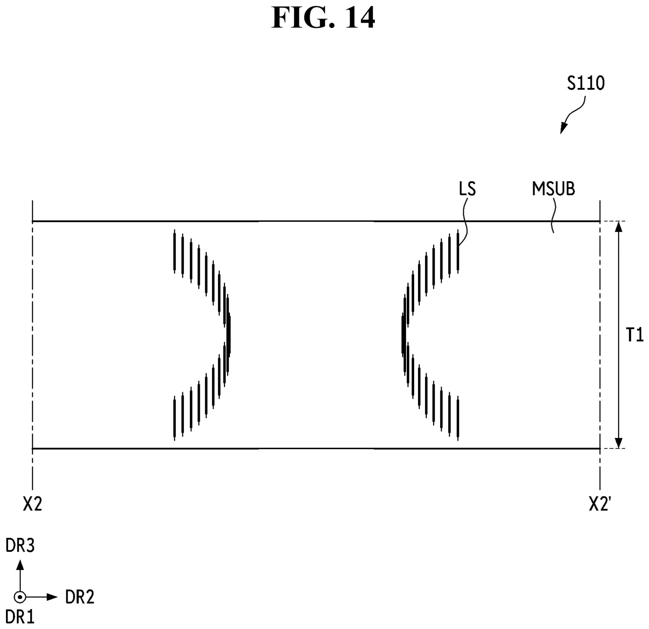

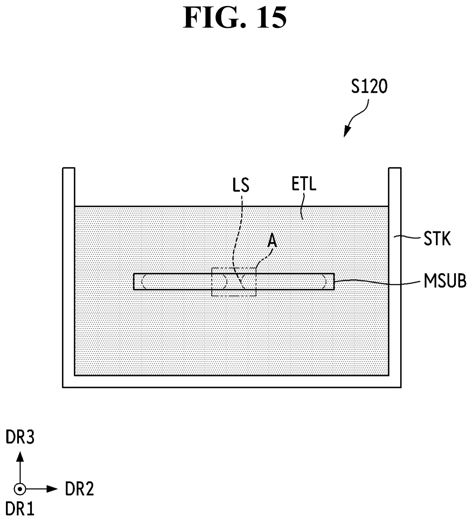

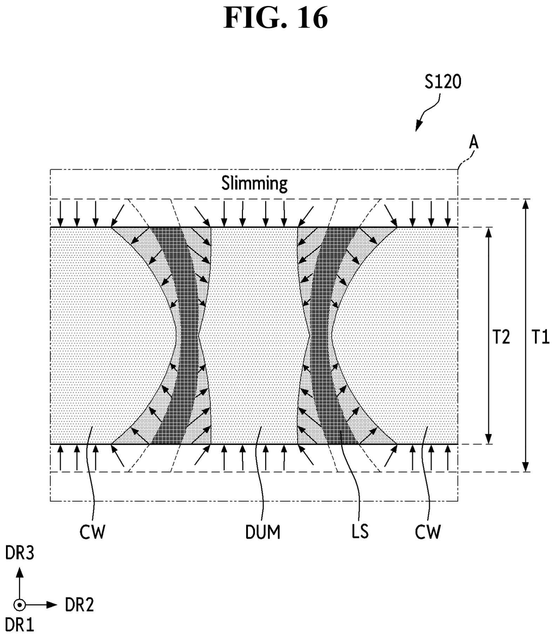

FIG. 12 is a flowchart for illustrating a method for fabricating a cover window according to one or more embodiments of the present disclosure. FIG. 13 is a perspective view showing step (e.g., act or task) S110 of FIG. 12 according to one or more embodiments. FIG. 14 is a cross-sectional view taken along the line X2 - X2' of FIG. 13 according to one or more embodiments. FIG. 15 is a cross-sectional view showing step (e.g., act or task) S120 of FIG. 12 according to one or more embodiments. FIG. 16 is an enlarged view of the area A of FIG. 15 according to one or more embodiments.

Referring to FIGS. 12 to 16 in conjunction with FIGS. 8 to 11, a method for fabricating a cover window according to one or more embodiments (S10) may include: irradiating a mother glass with a laser beam to form a sketch line for forming a plurality of cover windows (step (e.g., act or task) S110); and etching the mother glass using an etchant to separate the plurality of cover windows from the mother glass (step (e.g., act or task) S120).

Initially, as shown in FIGS. 13 and 14, sketch lines LS for forming cover windows CW may be drawn by irradiating a mother glass MSUB with a laser beam BM (step (e.g., act or task) S110 of FIG. 12).

A laser processing device LD may scan the laser beam BM along virtual lines to form the cover windows CW. The laser processing device LD may scan the laser beam BM along a virtual line corresponding to the first side surface SS1 of one of the plurality of cover windows CW. Then, the laser beam BM may be scanned along virtual lines corresponding to the second side surface SS2, the third side surface SS3, and the fourth side surface SS4 of the cover window CW. Once the laser processing device LD completes scanning the laser beam BM the virtual line corresponding to one of the cover windows CW, it may start scanning the laser beam BM along a virtual line corresponding to another one of the plurality of cover windows CW. The laser processing device LD may complete scanning the laser beam BM for all of the cover windows CW one after another.

After the scanning the laser beam BM is completed, the sketch lines LS corresponding to the first to fourth side surfaces SS1, SS2, SS3, and SS4 of each of the plurality of cover windows CW may be formed. As shown in FIG. 14, the sketch lines LS may have curved shapes similar to the first to fourth side surfaces SS1, SS2, SS3, and SS4 described above with reference to FIGS. 8 to 11 in a cross-section.

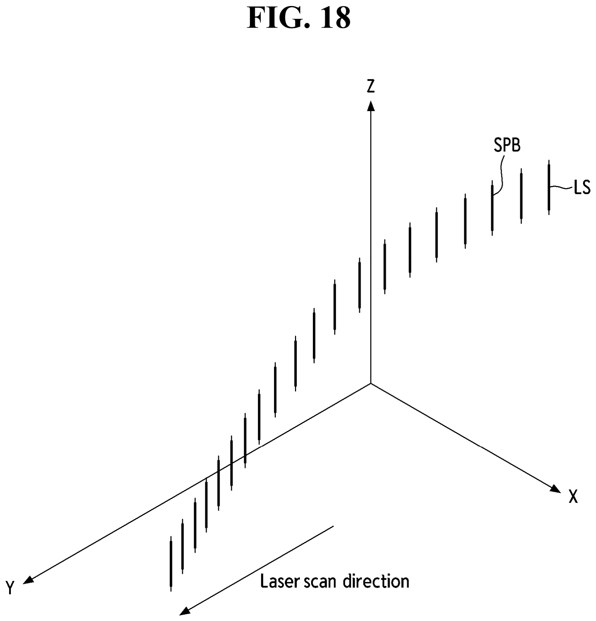

A sketch line LS may be formed as a plurality of spot beams SPB (see FIG. 18) is arranged. For example, the plurality of spot beams SPB (see FIG. 18) may be arranged in a C-shape on a plane defined by the first direction DR1 and the third direction DR3 or on a plane defined by the second direction DR2 and the third direction DR3.

In one or more embodiments, even after the sketch lines LS have been formed, the cover windows CW may not be separated from the mother glass MSUB. For example, the sketch lines LS may not be cutting lines that physically completely separate the cover windows CW from the mother glass MSUB, but may be processing lines that provide paths through which an etchant ETL may (e.g., can) permeate to form the shapes of the first to fourth side surfaces SS1, SS2, SS3, and SS4.

It should be understood, however, that embodiments of the present disclosure are not limited thereto. According to one or more embodiments, the sketch lines LS may be cutting lines that completely separate the cover windows CW from the mother glass MSUB. In the following descriptions, an example will be described in which the sketch lines LS are simple processing lines for permeation of the etchant ETL rather than cutting lines for convenience of illustration.

Subsequently, as shown in FIG. 15 and FIG. 16, the mother glass MSUB may be etched using the etchant ETL to separate the cover windows CW from the mother glass MSUB (step (e.g., act or task) S120 of FIG. 12).

The mother glass MSUB on which the sketch lines LS are formed may be etched by the etchant ETL. For example, in one or more embodiments, the mother glass MSUB may be immersed in the etchant ETL stored in a storage tank STK.

Accordingly, a thickness of each of the mother glass MSUB and the cover windows CW may be slimmed down to reduce from a first thickness T1 to a second thickness T2. For example, in one or more embodiments, the thickness of each of the mother glass MSUB and the cover windows CW may be reduced by approximately 20% to 50% relative to their initial thicknesses.

In addition, the etchant ETL may permeate into the sketch line LS, so that etching may proceed not only in the thickness direction of the cover window CW (e.g., the third direction DR3), but also in a direction from the sketch line LS toward the cover window CW and a direction from the sketch line LS toward a dummy DUM due to the isotropy of the etchant ETL. Accordingly, the first to fourth side surfaces SS1, SS2, SS3, and SS4 of the cover window CW may be formed along the shape of the sketch line LS.

By only using a laser process using the laser processing device LD and an etching process using the etchant ETL, each of the cover windows CW may be formed to have curved side surfaces SS1, SS2, SS3, and SS4 having a selected radius of curvature. Therefore, it may prevent or reduce defects such as wedges and chipping caused by a CNC process to fabricate a plurality of cover windows CW, thereby reducing the fabrication cost.

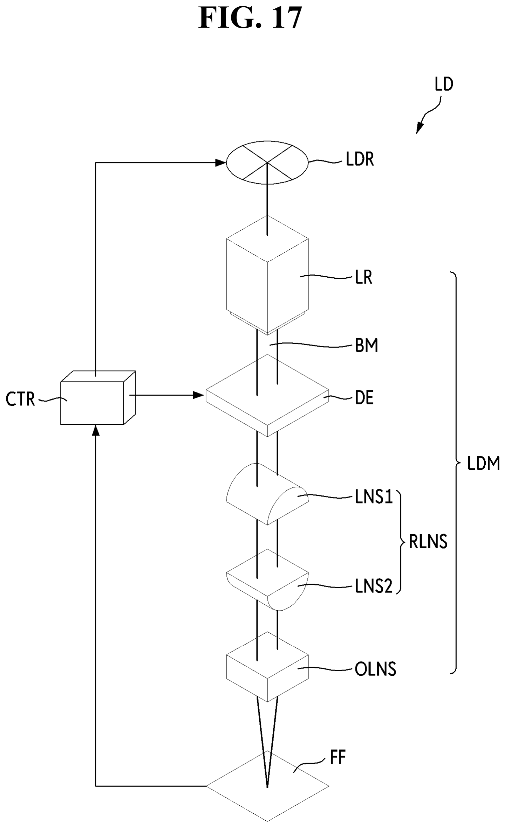

FIG. 17 is a perspective view showing an apparatus for fabricating a cover window according to one or more embodiments of the present disclosure.

Referring to FIG. 17, the laser processing device LD (or an apparatus for fabricating a cover window) according to one or more embodiments may be an apparatus for fabricating the cover window CW (see FIG. 12). For example, the laser processing device LD may form sketch lines LS (see FIG. 13) to form the cover window CW from the mother glass MSUB (see FIG. 13) using the laser beam BM.

The laser processing device LD according to one or more embodiments may include a laser module LDM, a laser scan driver LDR, and a controller CTR. The laser module LDM may include a light source LR, a diffractive element DE, a relay lens RLNS, and an objective lens OLNS.

The light source LR may be any of one or more suitable laser generating devices in the art. The light source LR may output a laser beam BM. The light source LR may output the laser beam BM continuously or discontinuously. The light source LR may output a laser beam BM with a single pulse, or a laser beam BM with a burst pulse including a plurality of pulses.

The pulse duration, burst pulse, pulse energy, repetition rate, and/or the like of the laser beam BM may be controlled or selected by the light source LR. For example, in one or more embodiments, the pulse period/duration (or pulse width) of the laser beam BM may be approximately about 300 fs (femto seconds) to about10 ps (pico seconds). The pulse energy of the laser beam BM may be approximately about 10 µJ to about 70 µJ, and the processing energy per individual spot may be 3 µJ/spot. The repetition rate of the laser beam BM may be approximately about 10 kHz to about 1,000 kHz. If (e.g., when) the light source LR outputs the laser beam BM with burst pulses, the burst pulse of the laser beam BM may be approximately 2 to 5 pulses.

A variety of laser beams may be used as the laser beam BM according to one or more embodiments. Herein, the laser beam BM may be an infrared beam having a wavelength range of approximately (about) 800 nanometers (nm) to (about) 1,100 nm.

The diffractive element DE may include a diffraction pattern for splitting a laser beam BM incident on the diffractive element DE into a plurality of spot beams SPB (see FIG. 18). The diffractive element DE may be either a diffractive optical element (DOE) having a fixed diffraction pattern, or a spatial light modulator (SLM) capable of actively changing diffraction patterns. For example, in one or more embodiments, the diffractive element DE may diffract a single laser beam BM incident from the light source LR and convert it into a plurality of spot beams SPB (see FIG. 18). The diffractive element DE may generate a plurality of spot beams SPB (see FIG. 18) by changing the phase and intensity of the laser beam BM.

In one or more embodiments, the relay lens RLNS may be placed between the diffractive element DE and the objective lens OLNS. In one or more embodiments, the relay lens RLNS may be arranged between the light source LR and the diffractive element DE. In one or more embodiments, the relay lens RLNS may not be utilized.

The relay lens RLNS may include a first lens LNS1 and a second lens LNS2. The first lens LNS1 may be adjacent to the diffractive element DE, and the second lens LNS2 may be adjacent to the objective lens OLNS.

According to one or more embodiments, the first lens LNS1 may be a convex lens that is convex in the direction of the diffractive element DE (i.e., toward the diffractive element DE), and the second lens LNS2 may be a convex lens that is convex in the direction of the objective lens OLNS (i.e., toward the objective lens OLNS). The relay lens RLNS may be to transmit light at a ratio of n:1 or 1:n, where n is a positive integer.

The objective lens OLNS may focus the laser beam BM passing through the relay lens RLNS at a distance. For example, the objective lens OLNS may focus the laser beam BM passing through the relay lens RLNS on a focal region FF.

In one or more embodiments, the objective lens OLNS may have a high numerical aperture (NA). For example, in one or more embodiments, the numerical aperture of the objective lens OLNS may be approximately 0.4 or greater. In one or more embodiments, the numerical aperture of the objective lens OLNS may be approximately about 0.5 to about 0.7.

The laser scan driver LDR may provide driving force to the laser module LDM so that the laser processing device LD may perform precise scanning work. The laser scan driver LDR may support rotational and/or linear movement desired or required for controlling the path of the laser beam BM. For example, in one or more embodiments, the laser scan driver LDR may include a variety of drivers well suitable in the art, such as a galvanometer scanner, a linear motor, a step motor, and/or a servo motor.

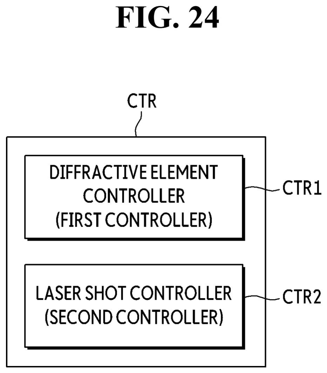

The controller CTR controls a final shape of the sketch lines LS formed by the laser beam BM, e.g., the arrangement and shape of the spot beams SPB (see FIG. 18), and provides a driving signal to the laser scan driver LDR to control the scanning of the laser module LDM. The controller CTR will be described in more detail later with reference to FIG. 24.

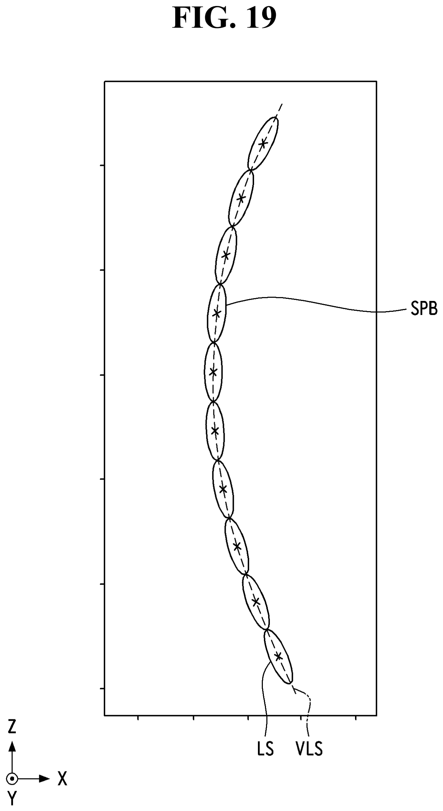

FIG. 18 is a view schematically showing a three-dimensional shape of a sketch line according to one or more embodiments. FIG. 19 is a view schematically showing a two-dimensional shape of a sketch line on the xz plane according to one or more embodiments.

In the following descriptions, the y-axis direction may be the scan direction of the laser processing device LD, the z-axis direction may be the same direction as the third direction DR3, which is the thickness direction of the mother glass MSUB or the cover window CW, and the x-axis direction may be a direction orthogonal to the y-axis direction and the z-axis direction.

Referring to FIG. 18 and FIG. 19 in conjunction with FIG. 17, the laser processing device LD may generate a sketch line LS of a curved shape located in the three-dimensional space defined by the x-axis, the y-axis, and the z-axis.

According to one or more embodiments of the present disclosure, a length of the sketch line LS in the x-axis direction may be approximately 200 µm or less. A length of the sketch line LS in the y-axis direction may be approximately 160 µm or less. A length of the sketch line LS in the z-axis direction may be approximately (about) 160 µm or less. It is, however, to be understood that the present disclosure is not limited thereto.

As shown in FIG. 19, the sketch line LS may be formed by arranging a plurality of spot beams SPB along a virtual curve VLS. Each of the spot beams SPB may have a generally elliptical shape. For example, each of the spot beams SPB may be extended in the major axis direction of the ellipse and may have a width in the minor axis direction of the ellipse.

The sketch line LS may be extended in a C-shape on the plane defined by the x-axis and the z-axis (hereinafter, referred to as the xz plane). For example, in one or more embodiments, the spot beams SPB, except for the spot beam SPB positioned at the center in the z-axis direction, may overlap with at least two spot beams SPB in the z-axis direction.

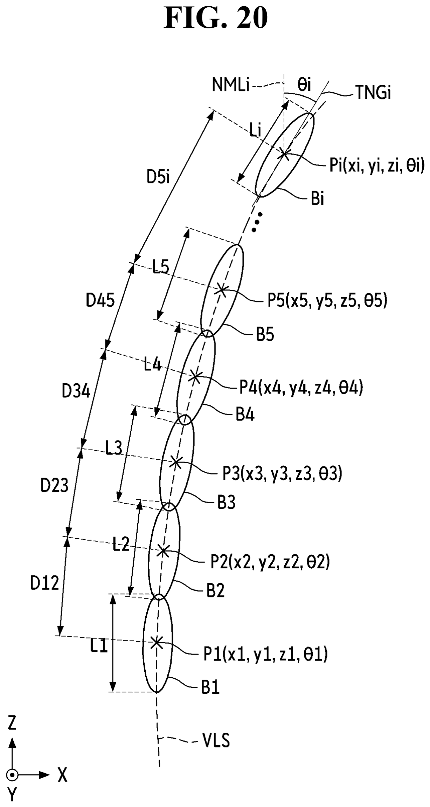

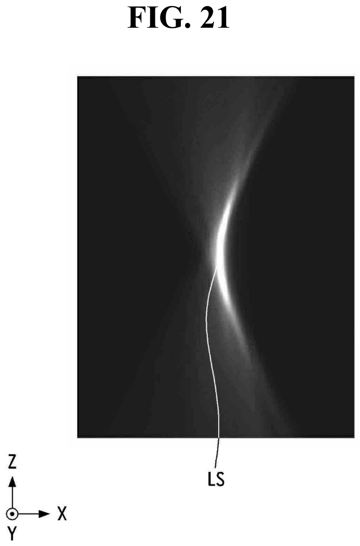

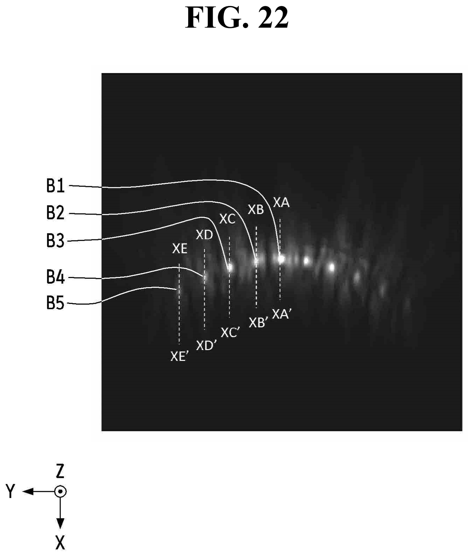

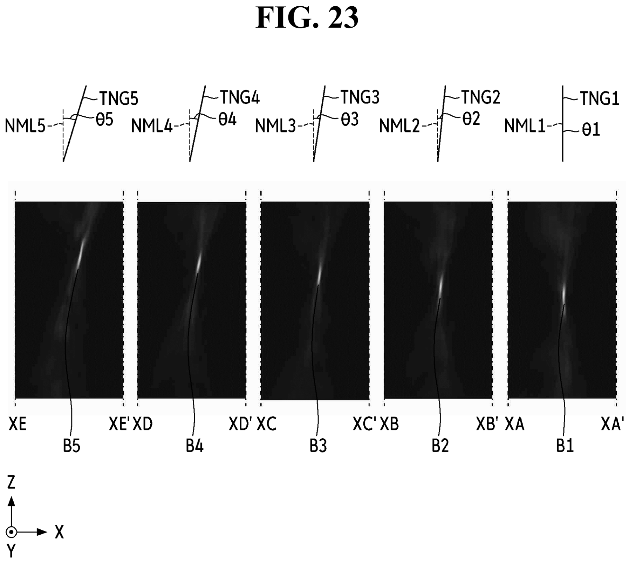

FIG. 20 is a view schematically showing a two-dimensional shape of a plurality of spot beams formed on the sketch line in the xz plane according to one or more embodiments. FIG. 21 is an image showing a two-dimensional shape of a sketch line on the xz plane according to one or more embodiments. FIG. 22 is an image showing a two-dimensional shape of the sketch line on the xy plane according to one or more embodiments. FIG. 23 is an image showing a two-dimensional shape of each of the spot beams in the xz plane, taken along the lines XA - XA', XB - XB', XC - XC', XD - XD', and XE - XE' of FIG. 22 according to one or more embodiments.

Referring to FIGS. 20 to 23 in conjunction with to FIGS. 17 to 19, the laser processing device LD may generate a sketch line LS including a plurality of spot beams SPB. The centers of the spot beams SPB of the sketch line LS may be each located on the virtual curve VLS.

For example, if the sketch line LS includes i spot beams SPB, the sketch line LS may include a first spot beam B1, a second spot beam B2, a third spot beam B3, a fourth spot beam B4, a fifth spot beam B5, ..., an i^{th} spot beam Bi.

The center P1 of the first spot beam B1 may be located at the point whose x-axis, y-axis, and z-axis coordinates are (x1, y1, z1), respectively. The center P2 of the second spot beam B2 may be located at the point whose x-axis, y-axis, and z-axis coordinates are (x2, y2, z2), respectively. The center P3 of the third spot beam B3 may be located at the point whose x-axis, y-axis, and z-axis coordinates are (x3, y3, z3), respectively. The center P4 of the fourth spot beam B4 may be located at the point whose x-axis, y-axis, and z-axis coordinates are (x4, y4, z4), respectively. The center P5 of the fifth spot beam B5 may be located at the point whose x-axis, y-axis, and z-axis coordinates are (x5, y5, z5), respectively. The center Pi of the i^{th} spot beam Bi may be located at the point whose x-axis, y-axis, and z-axis coordinates are (xi, yi, zi), respectively. The center P1 of the first spot beam B1, the center P2 of the second spot beam B2, the center P3 of the third spot beam B3, the center P4 of the fourth spot beam B4, the center P5 of the fifth spot beam B5, and the center Pi of the i^{th} spot beam Bi may each be located on the virtual curve VLS.

In one or more embodiments, the major axis lengths of the spot beams SPB may be substantially all equal. For example, the major axis length L1 of the first spot beam B1, the major axis length L2 of the second spot beam B2, the major axis length L3 of the third spot beam B3, the major axis length L4 of the fourth spot beam B4, the major axis length L5 of the fifth spot beam B5, and the major axis length Li of the i^{th} spot beam Bi may be substantially all equal. According to one or more embodiments of the present disclosure, the major axis length of each of the spot beams SPB may be approximately (about) 1 µm to (about) 20 µm.

It should be noted that if (e.g., when) the major axis lengths of the spot beams SPB have a difference of 5 µm or less, the major axis lengths of the spot beams SPB may be regarded to be substantially all equal. For example, even if the major axis lengths of the spot beams SPB are slightly different, the difference between the major axis lengths of the spot beams SPB may be about 5 µm or less.

In one or more embodiments, a spacing between the spot beams SPB may be substantially all equal. The spacing between the spot beams SPB refer to the shortest distance between the centers of two neighboring spot beams SPB. For example, the distance D12 between the center P1 of the first spot beam B1 and the center P2 of the second spot beam B2, the distance D23 between the center P2 of the second spot beam B2 and the center P3 of the third spot beam B3, the distance D34 between the center P3 of the third spot beam B3 and the center P4 of the fourth spot beam B4, the distance D45 between the center P4 of the fourth spot beam B4 and the center P5 of the fifth spot beam B5, and the distance D5i between the center P5 of the fifth spot beam B5 and the center Pi of neighboring i^{th} spot beam Bi may be substantially all equal.

It should be noted that if the spacing between the spot beams SPB has a difference of about 5 µm or less, it may be regarded that the spacing between the spot beams SPB is substantially all equal. For example, even if the spacing between the spot beams SPB are slightly different, the difference in the spacing between the spot beams SPB may be about 5 µm or less.

According to one or more embodiments of the present disclosure, the spacing between the spot beams SPB may be greater than about 0.5 times and less than about 1 time the major axis lengths of the spot beams SPB. Accordingly, the spot beams SPB may overlap with adjacent spot beams SPB at least partially. In addition, the centers of the spot beams SPB may not overlap with each other, and may be located at different points of the virtual curve VLS.

The laser processing device LD according to these embodiments may generate a plurality of spot beams SPB each tilted (or inclined) along the virtual curve VLS. The spot beams SPB may be each tilted such that they are extended in the direction of their respective tangents to the virtual curve VLS at their centers.

For example, as shown in FIG. 20 and FIG. 23, the first spot beam B1 may be tilted such that it is extended in the direction of a first tangent TNG1 that touches the virtual curve VLS at the center P1 of the first spot beam B1. The second spot beam B2 may be tilted such that it is extended in the direction of a second tangent TNG2 that touches the virtual curve VLS at the center P2 of the second spot beam B2. The third spot beam B3 may be tilted such that it is extended in the direction of a third tangent TNG3 that touches the virtual curve VLS at the center P3 of the third spot beam B3. The fourth spot beam B4 may be tilted such that it is extended in the direction of a fourth tangent TNG4 that touches the virtual curve VLS at the center P4 of the fourth spot beam B4. The fifth spot beam B5 may be tilted such that it is extended in the direction of a fifth tangent TNG5 that touches the virtual curve VLS at the center P5 of the fifth spot beam B5. The i^{th} spot beam Bi may be tilted such that it is extended in the direction of an i^{th} tangent TNGi that touches the virtual curve VLS at the center Pi of the second spot beam Bi.

The tilting angles of the spot beams SPB may be defined as the angles between the respective tangents and the vertical lines extended in the z-axis direction. For example, the tilting angle θ1 of the first spot beam B1 may be defined as an angle between the first tangent TNG1 and the first vertical line NML1 extended in the z-axis direction. The tilting angle θ2 of the second spot beam B2 may be defined as an angle between the second tangent TNG2 and the second vertical line NML2 extended in the z-axis direction. The tilting angle θ3 of the third spot beam B3 may be defined as an angle between the third tangent TNG3 and the third vertical line NML3 extended in the z-axis direction. The tilting angle θ4 of the fourth spot beam B4 may be defined as an angle between the fourth tangent TNG4 and the fourth vertical line NML4 extended in the z-axis direction. The tilting angle θ5 of the fifth spot beam B5 may be defined as an angle between the fifth tangent TNG5 and the fifth vertical line NML5 extended in the z-axis direction. The tilting angle θi of the i^{th} spot beam Bi may be defined as an angle between the i^{th} tangent TNGi and the i^{th} vertical line NMLi extended in the z-axis direction.

In one or more embodiments, the tilting angles of the spot beams SPB positioned at the center of the sketch line LS among the plurality of spot beams SPB may be smaller than the tilting angles of the spot beams SPB positioned at the edges of the sketch line LS. That is to say, the tilting angles of the spot beams SPB may increase as they move outward from the center of the sketch line LS.

Because the spot beams SPB are projected from the objective lens OLNS to the focal region FF, a maximum tilting angle of the spot beams SPB may be determined based on the numerical aperture of the objective lens OLNS. For example, the maximum tilting angle of each of the spot beams SPB may satisfy Equation 1: ${θ}_{M} = \frac{\left({NA}_{obj}-{NA}_{spot}\right)}{2} ,$

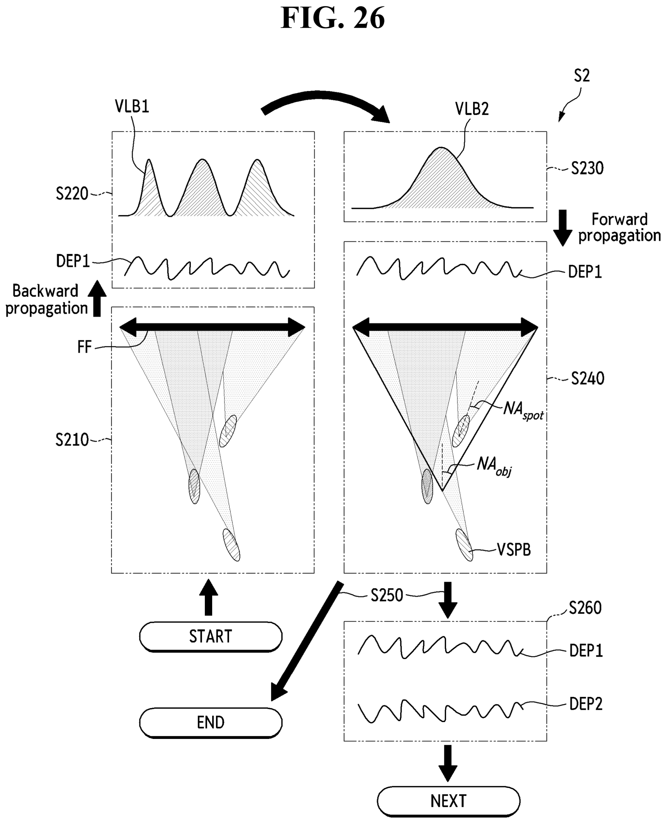

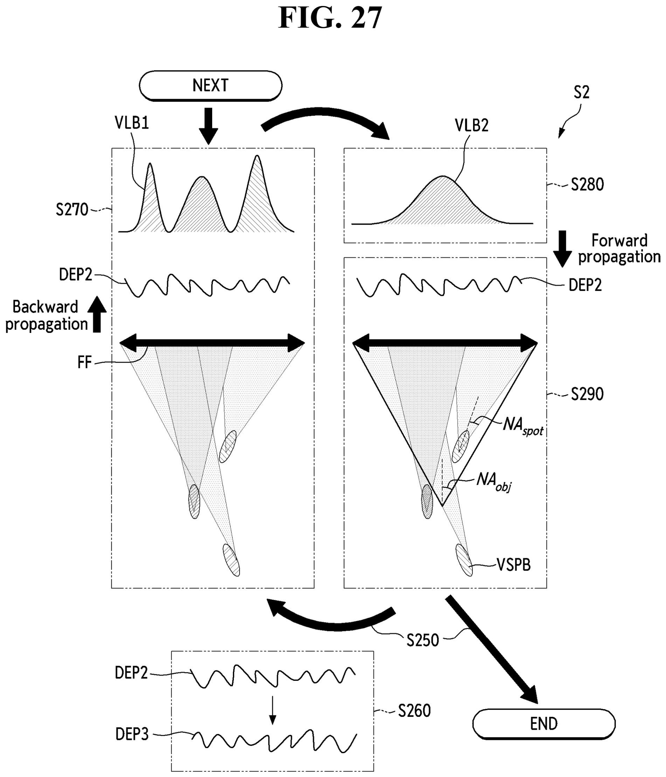

where θ_{M} denotes the maximum tilting angle, NA_{obj} denotes the numerical aperture of the objective lens OLNS, and NAₛₚₒₜ denotes the numerical aperture of each spot beam SPB. In one or more embodiments, the numerical aperture NA_{obj} of the objective lens OLNS (see FIGS. 26 and 27) may be approximately about 0.5 or more and about 0.7 or less, and the numerical aperture of each spot beam SPB (see FIGS. 26 and 27) may be approximately (about_ 0.3 or more and (about) 0.4 or less.

The numerical aperture of each of the spot beams SPB may satisfy Equation 2: ${NA}_{spot} = \frac{λ}{2 {d}_{spot}} ,$

where λ denotes the wavelength of the laser beam BM output from the light source LR, and dₛₚₒₜ denotes the major axis length of each spot beam SPB (e.g., Li in FIG. 20).

The laser device LD according to these embodiments may control not only parameters related to three-dimensional position coordinates of a plurality of spot beams SPB but also parameters related to tilting angles. The parameters related to the three-dimensional position coordinates of the plurality of spot beams SPB refer to the x-axis, y-axis, and z-axis coordinates of the spot beams SPB, and the parameters related to the tilting angles of the spot beams SPB refer to the sizes of the tilting angles of the spot beams SPB. For example, the parameters related to the three-dimensional position coordinates of the i^{th} spot beam Bi refer to xi, yi, and zi, and the parameters related to the tilting angles refer to θi.

As such, the final shape of the sketch line LS, such as the arrangement and shape of the spot beam SPB, may be controlled or selected by the controller CTR through the parameters related to the three-dimensional position coordinates of the spot beams SPB and the parameters related to the tilting angles. Hereinafter, the controller CTR that calculates and controls these parameters will be described.

FIG. 24 is a block diagram showing a controller of an apparatus for fabricating a cover window according to one or more embodiments of the present disclosure.

Referring to FIG. 24 in conjunction with FIGS. 17 and 18, the controller CTR may include a diffractive element controller (e.g., a first controller CTR1) and a laser shot controller (e.g., a second controller CTR2).

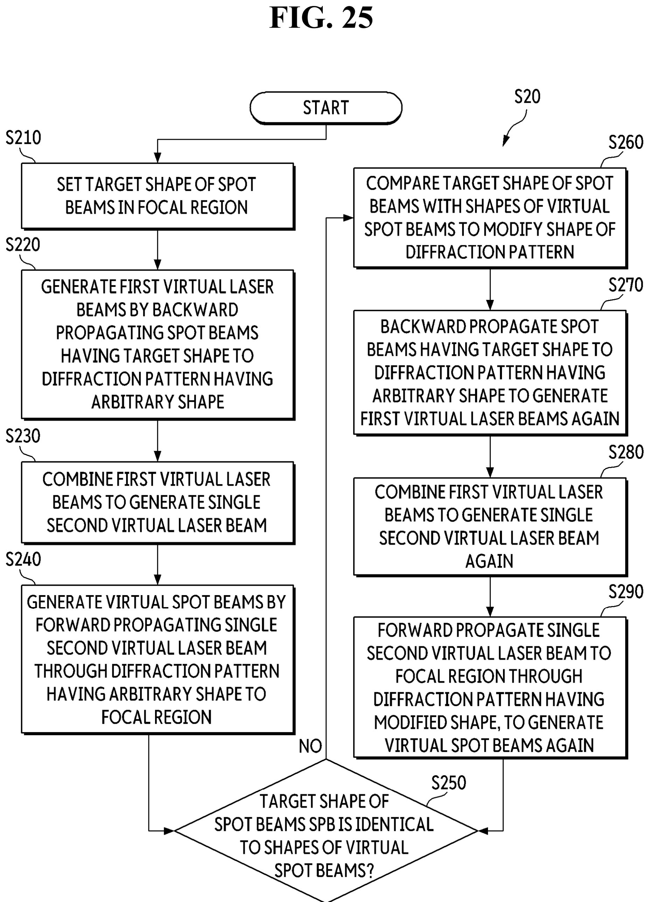

The diffractive element controller CTR1 may control the final shape of a sketch line LS, such as the arrangement and shape of the spot beams SPB. For example, in one or more embodiments, the diffractive element controller CTR1 may control the arrangement and shape of the spot beams SPB by controlling the shape of the diffraction pattern of the diffractive element DE. The diffractive element controller CTR1 may specify and calculate the parameters related to the three-dimensional position coordinates of the spot beams SPB and the parameters related to the tilting angles. A method how the diffractive element controller CTR1 controls the arrangement and shape of the spot beams SPB will be described later with reference to FIGS. 25 to 27.

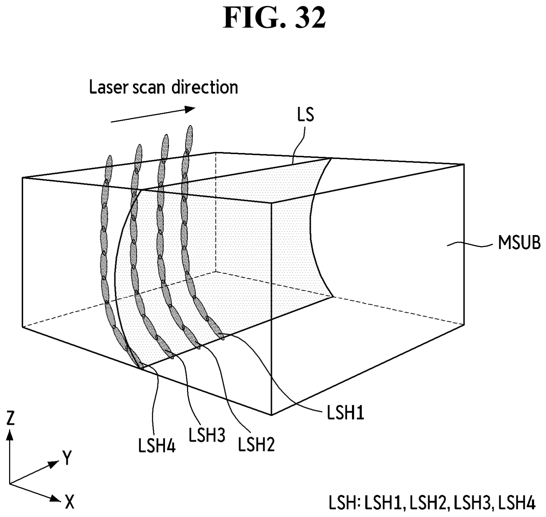

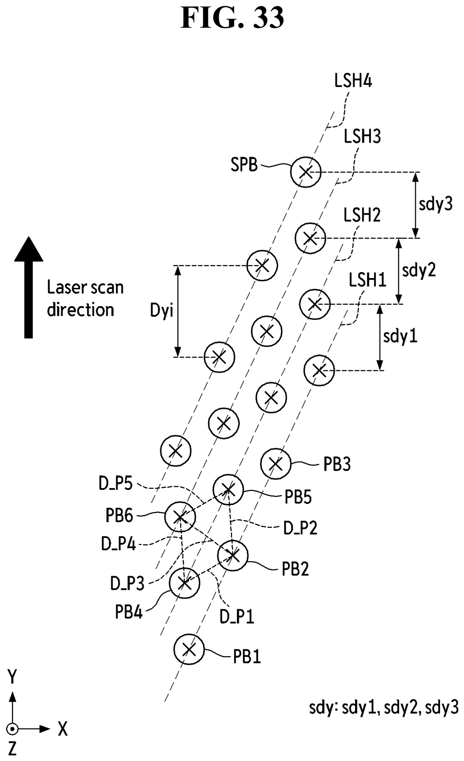

The laser shot controller CTR2 may control the spacing between spot beams SPB included in laser shots LSH (see FIG. 32) which will be described later. For example, the laser shot controller CTR2 may control the spacing between the spot beams SPB included in the laser shots LSH (see FIG. 32) by adjusting the pulse period of the light source LR or the scanning speed of the laser scan driver LDR. A method how the diffractive element controller CTR2 controls the spacing between the spot beams SPB included in the laser shots LSH (see FIG. 32) will be described in more detail with reference to FIGS. 32 and 33.

FIG. 25 is a flowchart for illustrating a process of optimizing the shape of the diffractive element by the diffractive element controller according to one or more embodiments. FIGS. 26 and 27 are views schematically showing the process of optimizing the shape of the diffractive element by the diffractive element controller according to one or more embodiments.

Referring to FIGS. 25 to 27 in conjunction with FIGS. 12 to 24, a process of enhancing or optimizing the shape of the diffractive element DE by the diffractive element controller CTR1 (step (e.g., act or task) S20) may be performed by repeating the process of modifying the shape of the diffractive element DE until a plurality of spot beams SPB is generated in a target shape.

For example, the diffraction element controller CTR1 may set the target shape of a plurality of spot beams SPB in the focal region FF (step (e.g., act or task) S210 of FIG. 25).

The target shape of the spot beams SPB refers to the shape of the spot beams SPB described with reference to FIGS. 18 to 23. The target shape of the spot beams SPB may be formed by the spot beams SPB superposing each other in the focal region FF. A plurality of spot beams SPB having the target shape may be used as a laser beam BM for forming a sketch line LS and for forming a cover window CW from a mother glass MSUB in the method S10 for fabricating a cover window.

Subsequently, the diffractive element controller CTR1 may generate a plurality of first virtual laser beams VLB1 by backward propagating a plurality of spot beams SPB having the target shape to a diffraction pattern having an arbitrary shape (step (e.g., act or task) S220 of FIG. 25).

For example, the diffractive element controller CTR1 may backward propagate a plurality of spot beams SPB having the target shape in the focal region FF to a first diffraction pattern DEP1 having an arbitrary shape. Then, first virtual laser beams VLB1 having a Gaussian beam shape corresponding to the respective spot beams SPB may be generated again.

The intensities of the first virtual laser beams VLB1 may be set to be all equal. The phases of the first virtual laser beams VLB1 may be randomly formed by the first diffraction pattern DEP1 having an arbitrary shape.

In one or more embodiments, the first virtual laser beams VLB1 may each have a Gaussian shape corresponding to the respective spot beams SPB. Each of the first virtual laser beams VLB1 may have converted phase and intensity as the spot beams SPB are back-propagated to the first diffraction pattern DEP1.

Subsequently, the diffractive element controller CTR1 may combine a plurality of first virtual laser beams VLB1 to generate a single second virtual laser beam VLB2 (step (e.g., act or task) S230 of FIG. 25).

In one or more embodiments, the second virtual laser beam VLB2 may have a truncated Gaussian shape or a top-hat shape. For example, in one or more embodiments, the second virtual laser beams VLB2 may be a single Gaussian beam formed by superposing the phases and intensities of the first virtual laser beams VLB1 that may each independently be the same or different from each other.

Subsequently, the diffractive element controller CTR1 may generate virtual spot beams VSPB by forward propagating one second virtual laser beam VLB2 through a diffraction pattern having an arbitrary shape to the focal region FF (step (e.g., act or task) S240 of FIG. 25).

For example, the light source LR may output the second virtual laser beam VLB2, and the second virtual laser beam VLB2 may be converted to virtual spot beams VSPB by the first diffraction pattern DEP1 having an arbitrary shape.

Subsequently, the diffractive element controller CTR1 may determine whether the target shape of the spot beams SPB is substantially identical (e.g., equal) to the shapes of the virtual spot beams VSPB (step (e.g., act or task) S250 of FIG. 25).

If (e.g., when) the target shape of the spot beams SPB is substantially identical (e.g., equal) to the shapes of the virtual spot beams VSPB (YES in S250), the process S20 of optimizing the shape of the diffractive element DE by the diffractive element controller CTR1 may be terminated. If (e.g., when) the target shape of the spot beams SPB is different from the shapes of the virtual spot beams VSPB (NO in S250), the diffractive element controller CTR1 may perform the next steps.

Subsequently, if (e.g., when) the target shape of the spot beams SPB is different from the shapes of the virtual spot beams VSPB (NO in S250), the diffractive element controller CTR1 may compare the target shape of the spot beams SPB with the shapes of the virtual spot beams VSPB to modify the shape of the diffraction pattern (step (e.g., act or task) S260 of FIG. 25).

For example, if the second virtual laser beam VLB2 is a Gaussian beam, it has the highest intensity at the center (even if it has a truncated Gaussian shape), the energy intensities of the virtual spot beams VSPB at the center may also be highest. Accordingly, the energy intensities of the virtual spot beams VSPB may be different (roughly the highest at the center). To reduce the surface roughness of the processed surface of the cover window CW, it is necessary to reduce the difference between the energy intensities of the virtual spot beams VSPB. Therefore, the diffractive element controller CTR1 may modify the shape of the diffraction pattern so that the difference between the energy intensities of the virtual spot beams VSPB is reduced.

Likewise, the virtual spot beams VSPB should be arranged or tilted identically to the spot beams SPB in the target shape so that the surface roughness of the processed surface of the cover window CW is reduced. Accordingly, the diffractive element controller CTR1 may modify the shape of the diffraction pattern so that the virtual spot beams VSPB should be arranged or tilted identically to the spot beams SPB in the target shape.

For example, as shown in FIG. 26, the shape of the first diffraction pattern DEP1 having an arbitrary shape may be modified to form a second diffraction pattern DEP2. The shape of the second diffraction pattern DEP2 may be different from the shape of the first diffraction pattern DEP1.

Subsequently, the diffractive element controller CTR1 may backward propagate a plurality of spot beams SPB having the target shape to a diffraction pattern having an arbitrary shape to generate a plurality of first virtual laser beams again (step (e.g., act or task) S270 of FIG. 25).

For example, the diffractive element controller CTR1 may backward propagate a plurality of spot beams SPB having the target shape in the focal region FF to the second diffraction pattern DEP2 having a modified shape. Then, first virtual laser beams VLB1 having a Gaussian beam shape corresponding to the respective spot beams SPB may be generated again.

At this time, the intensity and phase of each of the first virtual laser beams VLB1 may be determined by the second diffraction pattern DEP2 having the modified shape.

Subsequently, the diffractive element controller CTR1 may combine the first virtual laser beams VLB1 generated again to generate a single second virtual laser beam VLB2 (step (e.g., act or task) S280 of FIG. 25).

Subsequently, the diffractive element controller CTR1 may forward propagate the second virtual laser beam VLB2 generated again to the focal region FF through the diffraction pattern having the modified shape, to generate virtual spot beams VSPB again (step (e.g., act or task) S290 of FIG. 25).

For example, the light source LR may output the second virtual laser beam VLB2 generated again, and the second virtual laser beam VLB2 generated again may be converted to virtual spot beams VSPB by the second diffraction pattern DEP2 having the modified shape.

Subsequently, the diffractive element controller CTR1 may determine whether the target shape of the spot beams SPB is substantially identical (e.g., equal) to the shapes of the virtual spot beams VSPB generated again (step (e.g., act or task) S250 of FIG. 25).

If (e.g., when) the target shape of the spot beams SPB is substantially identical (e.g., equal) to the shapes of the virtual spot beams VSPB (YES in S250), the process S20 of optimizing the shape of the diffractive element DE by the diffractive element controller CTR1 may be terminated. If (e.g., when) the target shape of the spot beams SPB is different from the shapes of the virtual spot beams VSPB (NO in S250), the diffractive element controller CTR1 may sequentially perform steps S260, S270, S280, and S290 again.

For example, if (e.g., when) the target shape of the spot beams SPB is different from the shapes of the virtual spot beams VSPB (NO in S250), the diffractive element controller CTR1 may compare the target shape of the spot beams SPB with the shapes of the virtual spot beams VSPB to modify the shape of the second diffraction pattern, thereby generating a third diffraction pattern.

During the optimizing process, the diffractive element controller CTR1 may control the arrangement and shape of the spot beams SPB by controlling the shape of the diffraction pattern of the diffractive element DE.

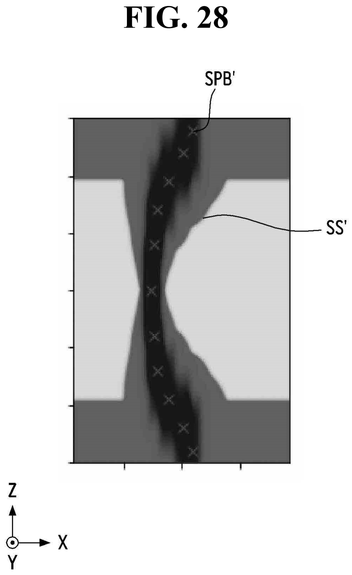

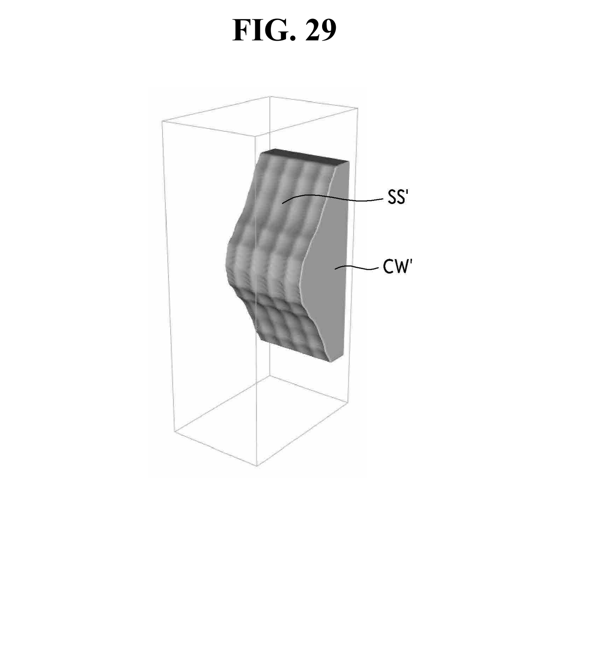

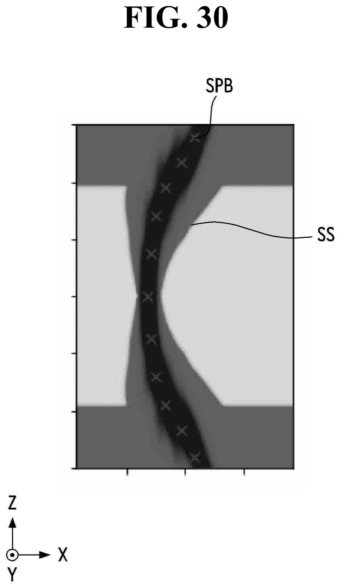

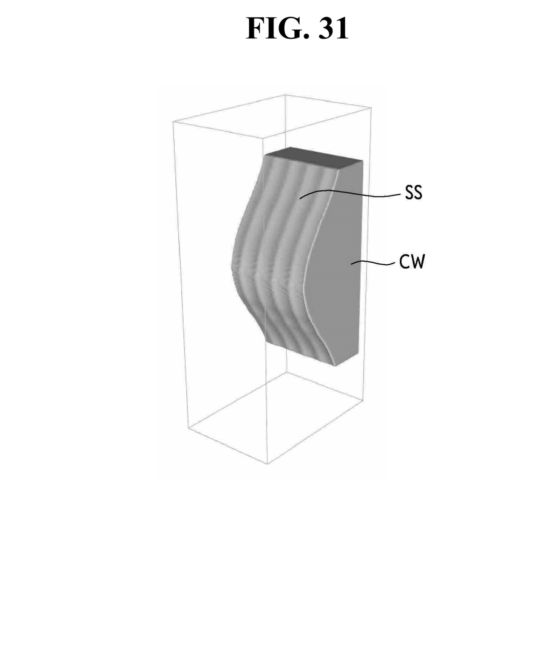

FIG. 28 is an image showing a cross-section of a cover window formed by a method for fabricating a cover window according to Comparative Example 1. FIG. 29 is an image showing a 3D shape of the cover window formed by the method for fabricating a cover window according to Comparative Example 1. FIG. 30 is an image showing a cross-section of a cover window formed by a method for fabricating a cover window according to one or more embodiments of the present disclosure. FIG. 31 is an image showing a 3D shape of the cover window formed by the method for fabricating a cover window according to one or more embodiments of the present disclosure.

Referring to FIGS. 28 to 31, according to the method for fabricating a cover window according to Comparative Example 1, a plurality of spot beams SPB' is each extended in the z-axis direction. That is to say, the spot beams SPB' may not be tilted with respect to the z-axis direction.

In contrast, according to the method for fabricating a cover window of the embodiments, a plurality of spot beams SPB is tilted with respect to the z-axis direction along the above-described virtual curve VLS (see FIG. 20).

It can be seen from FIG. 29 and FIG. 31 that the surface roughness of the side surface SS' of the cover window according to Comparative Example 1 is greater than the surface roughness of the side surface SS of the cover window according to the embodiments of the present disclosure.

According to the embodiments of the present disclosure, the laser processing device LD controls the arrangement and shape (e.g., tilting angle) of the spot beams SPB, so that the surface roughness of the side surface SS of the cover window may be reduced, thereby providing an excellent or suitable surface.

FIG. 32 is a perspective view showing a process of processing a mother glass with laser shots according to one or more embodiments of the present disclosure. FIG. 33 is a view schematically showing a process of optimizing the spacing between the spot beams included in the laser shots according to one or more embodiments.

Referring to FIG. 32 and FIG. 33 in conjunction with FIGS. 17, 18, and 24, in one or more embodiments, the laser processing device LD may move in the y-axis direction while scanning the mother glass MSUB. In one or more embodiments, a stage having a mother glass MSUB placed thereon may move in an opposite direction of the y-axis direction. The laser processing device LD may output laser shots LSH at regular (or irregular) intervals while scanning the mother glass MSUB.

The laser shot controller CTR2 of the laser processor device LD may control the spacing between the spot beams SPB included in the laser shots LSH by adjusting the pulse period of the light source LR or the scanning speed of the laser scan driver LDR.

For example, as shown in FIG. 33, the laser processing device LD may sequentially output a first laser shot LSH1, a second laser shot LSH2, a third laser shot LSH3, and a fourth laser shot LSH4 by the laser shot controller CTR2.

In one or more embodiments, an interval sdy1 between the first laser shot LSH1 and the second laser shot LSH2, an interval sdy2 between the second laser shot LSH2 and the third laser shot LSH3, an interval sdy3 between the third laser shot LSH3 and the fourth laser shot LSH4 may be equal to one another.

In one or more embodiments, the spacing Dyi between the spot beams SPB in the y-axis direction may be all equal in each of the first laser shot LSH1, the second laser shot LSH2, the third laser shot LSH3, and the fourth laser shot LSH4. For example, the spacing between the spot beams SPB included in the first laser shot LSH1 in the y-axis direction, the spacing between the spot beams SPB included in the second laser shot LSH2 in the y-axis direction, the spacing between the spot beams SPB included in the third laser shot LSH3 in the y-axis direction, and the spacing between the spot beams SPB included in the fourth laser shot LSH14 in the y-axis direction may be equal to one another.

According to one or more embodiments of the present disclosure, the first laser shot LSH1 may include a first spot beam PB1, a second spot beam PB2 and a third spot beam PB3, the second laser shot LSH2 may include a fourth spot beam PB4 and a fifth spot beam PB5, and the third laser shot LSH3 may include a sixth spot beam PB6.

The first spot beam PB1, the second spot beam PB2, and the third spot beam PB3 of the first laser shot LSH1 may be arranged in parallel in a diagonal direction inclined with respect to the x-axis and the y-axis in the plane defined by the x-axis and the y-axis (hereinafter referred to as the xy plane).

The fourth spot beam PB4 of the second laser shot LSH2 may be placed between the first spot beam PB1 and the second spot beam PB2 in the y-axis direction. The fourth spot beam PB4 of the second laser shot LSH2 may overlap with or may be parallel to the first spot beam PB1 in the x-axis direction. The fifth spot beam PB5 of the second laser shot LSH2 may be placed between the second spot beam PB2 and the third spot beam PB3 in the y-axis direction. The fifth spot beam PB5 of the second laser shot LSH2 may overlap with or may be parallel to the second spot beam PB2 in the x-axis direction.

The sixth spot beam PB6 of the third laser shot LSH3 may be placed between the fourth spot beam PB4 and the fifth spot beam PB5 in the y-axis direction. The sixth spot beam PB6 of the third laser shot LSH3 may overlap with or may be parallel to the fourth spot beam PB4 in the x-axis direction.

The laser shot controller CTR2 may derive an optimal variable k of a laser shot pitch that may (e.g., can) minimize surface roughness of the cover window CW from the spacing Dyi between the spot beams SPB of each of the laser shots LSH in the y-axis direction and the interval sdy between the laser shots LSH. The optimal variable k may satisfy Equation 3: $k = \frac{Δ {y}_{p}}{dy} ,$
where Δyₚ denotes the spacing Dyi between the spot beams SPB of each of the laser shots LSH in the y-axis direction (e.g., a distance between adjacent spot beams SPB of each of the laser shots LSH in the y-axis direction), dy denotes the interval sdy between the laser shots LSH (e.g., a distance between adjacent laser shots in the y-axis direction), and k denotes the optimal variable of the laser shot pitch that may minimize the surface roughness of the cover window CW. According to an embodiment of the present disclosure, the optimal variable k may be, but is not limited to, approximately about 1.25 to about 1.75.

Δyₚ, which refers to the spacing Dyi between adjacent spot beams SPB of each of the laser shots LSH in the y-axis direction, may be determined by the process S20 of optimizing the shape of the diffractive element DE by the diffractive element controller CTR1 as described above with reference to FIG. 25, and/or the like.

Therefore, the laser shot controller CTR2 may derive the optimal variable k by adjusting the dy value, which refers to the interval sdy between adjacent laser shots LSH, and tracking the change in surface roughness of the cover window CW.

In one or more embodiments, the optimal variable k may be derived if (e.g., when) the standard deviation of the shortest distances between adjacent ones of the spot beams SPB included in the laser shots LSH is minimized. That is to say, if (e.g., when) the laser shot controller CTR2 sets the interval sdy between the laser shots LSH so that the standard deviation of the shortest distances between adjacent ones of the spot beams SPB included in the laser shot LSH is minimized, the optimal variable k can be derived.

For example, the second spot beam PB2, the fourth spot beam PB4, the fifth spot beam PB5 and the sixth spot beam PB6 may be directly adjacent to one another. If the shortest distance D_P1 between the second spot beam PB2 and the fourth spot beam PB4, the shortest distance D_P2 between the second spot beam PB2 and the fifth spot beam PB5, the shortest distance D_P3 between the second spot beam PB2 and the sixth spot beam PB6, the shortest distance D_P4 between the fourth spot beam PB4 and the sixth spot beam PB6, and the shortest distance D_P5 between the fifth spot beam PB5 and the sixth spot beam PB6 are all equal, the standard deviation of the shortest distances between adjacent spot beams SPB may be minimized or reduced to be zero. The optimal variable k may be derived using dy and Δyₚ at this time.

In one or more embodiments, in the process of deriving the optimal variable k, the initial value of the interval sdy between the laser shots LSH (e.g., adjacent laser shots LSH) and the initial value of the spacing Dyi between the (neighboring) spot beams SPB in the y-axis direction in each of the laser shots LSH may be set to be larger than the diameters of the spot beams SPB. Accordingly, in the process of deriving the optimal variable k, it may prevent or reduce confusion due to interference between adjacent spot beams SPB.

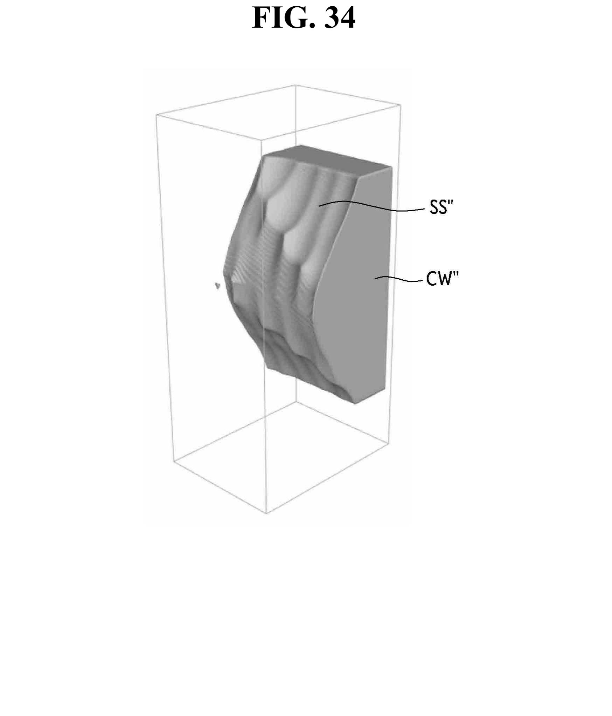

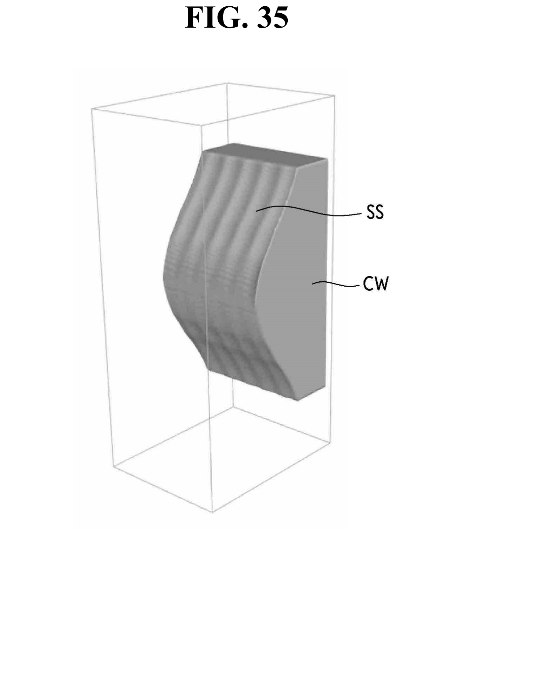

FIG. 34 is an image showing a 3D shape of a cover window formed by a method for fabricating a cover window according to Comparative Example 2. FIG. 35 is an image showing a 3D shape of the cover window formed by the method for fabricating a cover window according to one or more embodiments of the present disclosure.

Referring to FIGS. 34 and 35 in conjunction with FIGS. 32 and 33, a cover window CW" fabricated by the method for fabricating a cover window according to Comparative Example 2 is formed by outputting laser shots LSH not with the optimal variable k. For example, the cover window CW" fabricated by the method of fabricating a cover window according to Comparative Example 2 is formed while the interval sdy between the laser shots LSH is not optimized.

In contrast, the cover window CW according to the method of fabricating a cover window according to the embodiments of the present disclosure is formed by outputting laser shots LSH with the optimal variable k. That is to say, the cover window CW according to the method of fabricating a cover window according to the embodiments of the present disclosure is formed with the optimal interval sdy between the laser shots LSH.

It can be seen from FIG. 34 and FIG. 35 that the surface roughness of the side surface SS' of the cover window CW" according to Comparative Example 2 is greater than the surface roughness of the side surface SS of the cover window CW according to the embodiments of the present disclosure.

According to one or more embodiments of the present disclosure, the laser processing device LD controls the spacing between the spot beams SPB including in laser shot LSH (see FIG. 32), so that the surface roughness of the side surface SS of the cover window may be reduced, thereby providing an excellent or suitable surface.

The display device 10 including the cover window CW according to the above-described embodiments may be applied to a variety of electronic devices. The electronic device according to one or more embodiments may include the display device 10 including the above-described cover window CW, and may further include a module or a device having additional functions in addition to the display device 10 including the cover window CW.

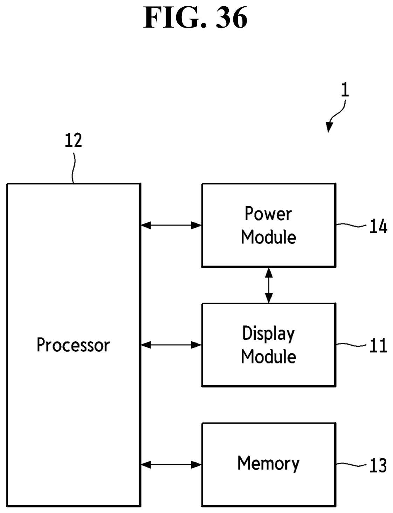

FIG. 36 is a block diagram of an electronic device according to one or more embodiments of the present disclosure.

Referring to FIG. 36, an electronic device 1 according to one or more embodiments of the present disclosure may include a display module 11, a processor 12, a memory 13, and a power module 14.

The processor 12 may include at least one of: a central processing unit (CPU), an application processor (AP), a graphic processing unit (GPU), a communication processor (CP), an image signal processor (ISP), or a controller.

The memory 13 may store data information desired or required for operations of the processor 12 and/or the display module 11. When the processor 12 executes an application stored in the memory 13, an image data signal and/or an input control signal may be transmitted to the display module 11. The display module 11 may process the received signal and output image information through a display screen.

The power module 14 may include a power supply module such as a power adapter and/or a battery device, and a power conversion module that converts the power supplied by the power supply module to generate power desired or required for the operation of the electronic device 1.

At least one of the elements of the electronic device 1 described above may be included in the display device 10 according to one or more embodiments described above. In addition, some of the individual modules functioning as a single module may be included in the display device 10 while some others may be provided separately from the display device 10. For example, the display device 10 may include the display module 11, and the processor 12, the memory 13, and the power module 14 may be provided as other devices inside the electronic device 1 than the display device 10.

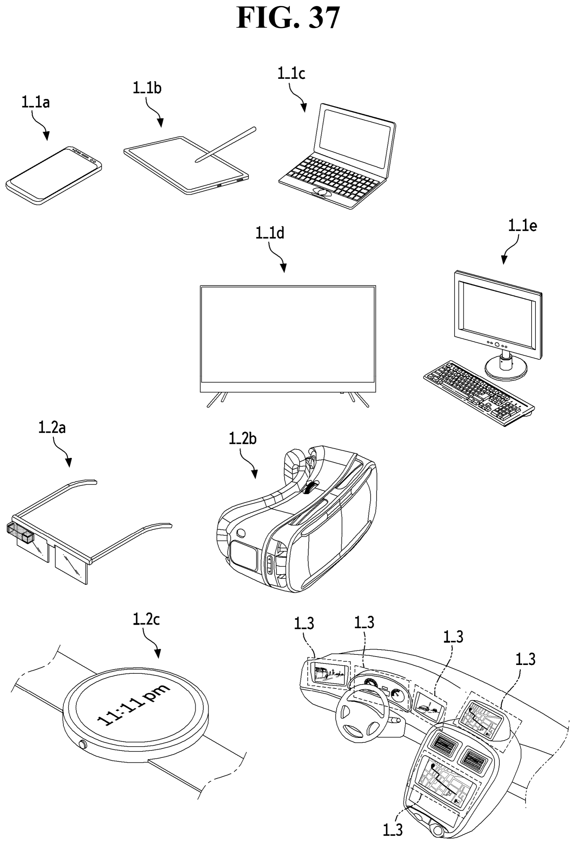

FIG. 37 is a view showing electronic devices according to a variety of embodiments of the present disclosure.

Referring to FIG. 37, a variety of electronic devices 1 employing the display devices 10 according to one or more embodiments may include not only image display electronic devices such as a smart phone 1_1a, a tablet PC 1_1b, a laptop computer 1_1c, a TV 1_1d and/or a desktop monitor 1_1e, but also wearable electronic devices including display modules such as smart glasses 1_2a, a head-mounted display 1_2b, and/or a smart watch 1_2c, and/or may also include electronic devices for vehicles 1_3 including display modules such as a center information display (CID) placed on a dashboard, a center fascia, and/or a dashboard of a vehicle, and/or a room mirror display thereof. These various implementations demonstrate the applicability of the disclosed cover window fabrication technology across a wide range of consumer and/or industrial electronic devices, particularly where durability, optical clarity, and/or precise edge finishing are desired.

In the present disclosure, it will be understood that the terms "comprise(s)/comprising," "include(s)/including," or "have/has/having" specify the presence of stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having," or other similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

As utilized herein, the singular forms "a," "an," "one," and "the" are intended to include the plural forms as well, unless the context clearly indicates otherwise. Further, the use of "may" when describing embodiments of the present disclosure refers to "one or more embodiments of the present disclosure". In addition, the terms "first," "second," "third," and/or the like, may be used herein to describe one or more suitable elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section described below could be termed a second element, component, region, layer, or section, without departing from the scope of the present disclosure as defined by the appended claims.

In the present disclosure, expressions such as "at least one of," "one of," and "selected from," when preceding a list of elements, modify the entire list of elements and do not modify the individual elements of the list. For example, "at least one of a, b or c", "at least one selected from a, b, and c", "at least one selected from among a to c", etc., may indicate only a, only b, only c, both (e.g., simultaneously) a and b, both (e.g., simultaneously) a and c, both (e.g., simultaneously) b and c, all of a, b, and c, or variations thereof. The "/" utilized herein may be interpreted as "and" or as "or" depending on the situation.

In the context of the present application and unless otherwise defined, the terms "use," "using," and "used" may be considered synonymous with the terms "utilize," "utilizing," and "utilized," respectively.

As utilized herein, the terms "substantially," "about," "approximately," or similar terms are used as terms of approximation and not as terms of degree, and are intended to account for the inherent deviations in measured or calculated values that would be recognized by those of ordinary skill in the art. "About" or "approximately" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, ± 20%, ± 10%, or ± 5% of the stated value. Also, it should be understood that, even if the terms "about," "approximately," or "substantially" are not expressly recited in a given element (e.g., a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (e.g., claim elements) should be construed accordingly to encompass such equivalents.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in the present disclosure is intended to include all higher numerical limitations subsumed therein. Accordingly, Applicant reserves the right to amend the disclosure, including the claims, to expressly recite any sub-range subsumed within the ranges expressly recited herein.

The light emitting element, the display panel, the display device, the electronic device/apparatus, the cover window-manufacturing apparatus, or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random-access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure as defined by the appended claims.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In concluding the detailed description, those skilled in the art will appreciate that many variations and modifications can be made to the embodiments without substantially departing from the principles of the present disclosure. Therefore, the disclosed embodiments of the invention are used in a generic and descriptive sense only and not for purposes of limitation.

## Claims

1. An apparatus (LD) for fabricating a cover window (CW), comprising:
a laser module (LDM); and
a laser scan driver (LDR) configured to drive the laser module (LDM),
wherein the laser module (LDM) comprises:
a light source (LR) configured to output a first laser beam (BM);
a diffractive element (DE) configured to diffract the first laser beam (BM) and convert it into a second laser beam comprising a plurality of spot beams (SPB) arranged along a virtual first curve (VLS); and
an objective lens (OLNS) configured to focus the second laser beam onto a focal region (FF),
wherein the spot beams (SPB) are extended in different directions.

2. The apparatus (LD) of claim 1, wherein centers of the spot beams (SPB) are located at different points along the virtual first curve (VLS), and
wherein each of the spot beams (SPB) is extended in a direction of a respective tangent that touches the virtual first curve (VLS) at the center of that spot beam (SPB); and/or
wherein the spot beams (SPB) overlap with adjacent ones at least partially.

3. The apparatus (LD) of claim 1 or 2, wherein the diffractive element (DE) comprises a diffraction pattern that diffracts the first laser beam (BM) and converts it into the second laser beam,
wherein the apparatus (LD) further comprises a first controller (CTR1) configured to control a shape of the diffraction pattern to adjust arrangement and shape of the spot beams (SPB), and
wherein the first controller (CTR1) is configured to set first, second, and third parameters that specify three-dimensional position coordinates related to arrangement of each of the spot beams (SPB), and a fourth parameter that specifies a tilting angle associated with a shape of each of the spot beams (SPB).

4. The apparatus (LD) of claim 3, wherein a maximum tilting angle of each of the spot beams (SPB) is θ_{M}, a numerical aperture of the objective lens (OLNS) is NA_{obj}, a numerical aperture of each of the spot beams (SPB) is NAₛₚₒₜ, and a maximum tilting angle of each of the spot beams (SPB) satisfies the equation of: ${θ}_{M} = \frac{\left({NA}_{obj}-{NA}_{sport}\right)}{2} .$

5. The apparatus (LD) of claim 4, wherein a wavelength of the first laser beam (BM) is λ, a major axis length of each of the spot beams (SPB) is dₛₚₒₜ, and the numerical aperture NAₛₚₒₜ of each of the spot beams (SPB) satisfy the equation of: ${NA}_{spot} = \frac{λ}{2 {d}_{spot}} .$

6. The apparatus (LD) of claim 4 or 5, wherein the numerical aperture of the objective lens (OLNS) is 0.5 to 0.7, and
wherein the numerical aperture of each of the spot beams (SPB) is 0.3 to 0.4.

7. The apparatus (LD) of any one of claims 3 to 6, wherein the first controller (CTR1) is configured to perform a first operation process, a second operation process, and a third operation process,
wherein the first operation process comprises: setting a target shape of the plurality of spot beams (SPB) in the focal region (FF); generating a plurality of first virtual laser beams (VLB1) by back-propagating the plurality of spot beams (SPB) having the target shape to the diffraction pattern having an arbitrary shape; generating a single second virtual laser beam (VLB2) by combining the plurality of first virtual laser beams (VLB1); and generating virtual spot beams (SPB) by forward-propagating the single second virtual laser beam (VLB2) to the focal region (FF) through the diffraction pattern having the arbitrary shape,
wherein the second operation process comprises: determining whether the target shape of the plurality of spot beams (SPB) is identical to shapes of the virtual spot beams (SPB), wherein the first controller (CTR1) terminates the first to third operation processes when the target shape of the spot beams (SPB) is identical to the shapes of the virtual spot beams (SPB), or performs the third operation process when the target shape of the spot beams (SPB) is different from the shapes of the virtual spot beams (SPB),
wherein the third operation process comprises: modifying the shape of the diffraction pattern by comparing the target shape of the spot beams (SPB) with the shapes of the virtual spot beams (SPB); regenerating the plurality of first virtual laser beams (VLB1) by back-propagating the plurality of spot beams (SPB) having the target shape through the diffraction pattern having the modified shape; combining the plurality of first virtual laser beams (VLB1) to regenerate the single second virtual laser beam; and regenerating the virtual spot beams (SPB) by forward propagating the single second virtual laser beam (VLB2) to the focal region (FF) through the diffraction pattern having the modified shape, and
wherein the first controller (CTR1) is configured to repeat the second operation process and the third operation process until the target shape of the plurality of spot beams (SPB) is identical to the shapes of the virtual spot beams (SPB).

8. The apparatus (LD) of any one of the preceding claims, wherein the laser module (LDM) is configured to receive a driving force from the laser scan driver (LDR) and to move in a first direction (DR1), and to output a plurality of laser shots (LSH) each comprising the plurality of spot beams (SPB),
wherein the apparatus (LD) further comprises: a second controller (CTR2) configured to control an interval (sdy) of the laser shots (LSH) in the first direction (DR1), and
wherein the second controller (CTR2) is configured to control the interval (sdy) so that a standard deviation of shortest distances between adjacent ones of the spot beams (SPB) of each of the laser shots (LSH) is minimized.

9. The apparatus (LD) of claim 8, wherein the laser shots (LSH) comprise a first laser shot (LSH1), a second laser shot (LSH2), and a third laser shot (LSH3) each comprising the plurality of spot beams (SPB),
wherein the first laser shot (LSH1) comprises first to third spot beams (B1, B2, B3) each arranged along a second direction (DR2) different from the first direction (DR1), the second laser shot (LSH2) comprises fourth and fifth spot beams (B4, B5) each arranged along the second direction (DR2), and the third laser shot comprises a sixth spot beam (B6),
wherein the fourth spot (B4) beam is arranged between the first and second spot beams (B1 B2) in the first direction (DR1), the fifth spot (B5) beam is arranged between the second and third spot beams (B2, B3) in the first direction (DR1), and the sixth spot (B6) beam is arranged between the fourth and fifth spot beams (B4, B5), and
wherein the second controller (CTR2) is configured to control the interval (sdy) so that a shortest distance (D_P1) between the second spot beam (B2) and the fourth spot beam (B4), a shortest distance (D_P2) between the second spot beam (B2) and the fifth spot beam (B5), a shortest distance (D_P3) between the second spot beam (B2) and the sixth spot beam (B6), a shortest distance (D_P4) between the fourth spot beam (B4) and the sixth spot beam (B6), and a shortest distance (D_P5) between the fifth spot beam (B5) and the sixth spot beam (B6) are equal to one another.

10. The apparatus (LD) of claim 9, wherein an interval (sdy) between the first laser shot (LSH1) and the second laser shot (LSH2) in the first direction (DR1) is equal to an interval between the second laser shot (LSH2) and the third laser shot (LSH3); and/or
wherein a spacing (Dyi) between adjacent spot beams (SPB) is all equal in each of the laser shots (LSH).

11. A method for fabricating a cover window (CW), comprising:
forming a sketch line (LS) for forming a cover window (CW) by irradiating a mother glass (MSUB) with a laser beam; and
etching the mother glass (MSUB) utilizing an etchant (ETL) to separate the cover window (CW) from the mother glass (MSUB),
wherein the laser beam comprises a plurality of spot beams (SPB) arranged along a virtual first curve (VLS),
wherein the spot beams (SPB) are extended in different directions.

12. The method of claim 11, wherein a thickness (T1) of the mother glass (MSUB) is reduced by the etching with the etchant (ETL), and
wherein the etchant (ETL) permeates the sketch line (LS) to form a side surface (SS) of the cover window (CW) along a shape of the virtual first curve (VLS).

13. The method of claim 11 or 12, wherein the sketch line (LS) is formed by a plurality of laser shots (LSH) formed by outputting the laser beam multiple times,
wherein a spacing (Dyi) between adjacent spot beams (SPB) in each of the plurality of laser shots (LSH) in a scan direction of the laser beam is Δyₚ,
wherein an interval (sdy) between the plurality of laser shots (LSH) in the scan direction of the laser beam is dy,
wherein an optimal variable capable of minimizing a surface roughness of the cover window (CW) is k, and
wherein the k satisfies the equation of: $k = \frac{Δ {y}_{p}}{dy} .$

14. The method of claim 13, wherein an initial value of the Δyₚ is set to be larger than a diameter of each of the spot beams (SPB) in a process of deriving the optimal variable k.

15. An electronic device (1), comprising:
a display device (10) comprising a cover window (CW) fabricated by an apparatus (LD) for fabricating a cover window (CW) of any one of claims 1 to 10 or by a method of any one of claims 11 to 14, and a display panel (100) located under the cover window (CW);
a processor (12) configured to provide a driving signal to the display device (10); and
a power module (14) configured to provide power to the display device (10)
